# EUROPEAN PATENT APPLICATION

(11) **EP 3 972 079 A1**
(43) Date of publication of application: **23.03.2022**
(21) Application number: 20827510.7
(22) Date of filing: 27.05.2020
(51) Int. Cl.: H02J 7/04

(54) **DRIVING CIRCUIT, ELECTRONIC DEVICE, AND CONTROLLED CHARGING METHOD**

(30) Priority: 19.06.2019 CN 201910532974
(71) Applicant: GUANGDONG OPPO MOBILE TELECOMMUNICATIONS CORP., LTD., Dongguan, Guangdong 523860 (CN)
(72) Inventor: LIU, Shaobin, Dongguan, Guangdong 523860 (CN); TIAN, Chen, Dongguan, Guangdong 523860 (CN); BU, Changjun, Dongguan, Guangdong 523860 (CN); ZHANG, Jun, Dongguan, Guangdong 523860 (CN)
(74) Representative: Manitz Finsterwald Patent- und Rechtsanwaltspartnerschaft mbB
(86) International application number: PCT/CN2020/092596
(87) International publication number: WO 2020/253482

(57) **Abstract**

A driving circuit (380), an electronic device (1800), and a controlling charging method (1900), comprising: a first interface (610), used for receiving a direct-current signal inputted by an external power supply device; a second interface (620), used for receiving at least two pulse-width modulation (PWM) signals; and a processing circuit (630), used for overlaying and rectifying the direct-current signal and the at least two PWM signals so as to acquire a first direct-current signal, and outputting the first direct-current signal to a gate electrode of an MOS transistor. The driving circuit is capable of increasing a driving voltage generated by the driving circuit, thus increasing the voltage between a gate electrode and a source electrode between MOS transistors, thus preventing the voltage of a VGS from dropping too low resulting in reduced charging efficiency, a reduced fast-charging current or quitting a fast-charging mode.

## Description

### CROSS-REFERENCE TO RELATED APPLICATION

This application claims priority to Chinese patent application No. 201910532974.7 filed with the CNIPA on June 19, 2019, the disclosure of which is hereby incorporated by reference in its entirety.

### TECHNICAL FIELD

The embodiments of the disclosure relates to a field of charging technologies, and particularly to a driving circuit, an electronic circuit and a method for controlling charging.

### BACKGROUND

With electronic devices (such as a mobile phone, a pad, a bracelet) become popular, functions of electronic devices are constantly enriched. Some manufacturers have launched electronic devices that support a fast charge mode. Fast charge technologies greatly shorten a charging time of the electronic devices, which is widely favored by users.

### SUMMARY

The embodiments of the disclosure provides a driving circuit, an electronic circuit and a method for controlling charging to solve the charging problem in the related art.

In a first aspect, the disclosure provides a driving circuit. The driving circuit is located on a mainboard of an electronic device, and the electronic device further includes a MOS transistor and a micro-controller unit (MCU). The driving circuit includes: a first interface connected to an external power supply apparatus, configured to receive a direct current signal input by the external power supply apparatus; a second interface connected to the MCU, configured to receive at least two pulse width modulated PWM signals input by the MCU; and a processing circuit connected to the first interface and the second interface respectively, configured to acquire a first direct current signal by superimposing and rectifying the direct current signal and the at least two PWM signals and output the first direct current signal to a gate of the MOS transistor, to enable a voltage of the gate of the MOS transistor to be greater than a first threshold.

In a second aspect, the disclosure provides an electronic device. The electronic device includes: a first interface connected to an external power supply apparatus, configured to receive a direct current signal input by the external power supply apparatus; a micro-controller unit (MCU); a second interface connected to the MCU, configured to receive at least two pulse width modulated PWM signals input by the MCU; a MOS transistor; and a processing circuit connected to the first interface and the second interface respectively, configured to acquire a first direct current signal by superimposing and rectifying the direct current signal and the at least two PWM signals, and output the first direct current signal to a gate of the MOS transistor, to enable a voltage of the gate of the MOS transistor to be greater than a first threshold.

In a third aspect, the disclosure provides a method for controlling charging. The method includes: acquiring a first direct current signal by superimposing and rectifying a direct current signal input by an external power supply apparatus through a first interface and at least two PWM signals input by a MCU through a second interface; and outputting the first direct current signal to a gate of a MOS transistor, to enable a voltage of the gate of the MOS transistor to be greater than a first threshold.

In a fourth aspect, the disclosure provides a computer readable storage medium having computer programs stored thereon, in which the computer programs are configured for causing a computer to execute the method as described in the third aspect or in any one of implementations. The method in the third aspect includes: acquiring a first direct current signal by superimposing and rectifying a direct current signal input by an external power supply apparatus through a first interface and at least two PWM signals input by a MCU through a second interface; and outputting the first direct current signal to a gate of a MOS transistor, to enable a voltage of the gate of the MOS transistor to be greater than a first threshold.

In a fifth aspect, the disclosure provides a computer program product including computer instructions, the computer instructions are caused a computer to execute the method as described in the third aspect or in any one of implementations. The method in the third aspect includes: acquiring a first direct current signal by superimposing and rectifying a direct current signal input by an external power supply apparatus through a first interface and at least two PWM signals input by a MCU through a second interface; and outputting the first direct current signal to a gate of a MOS transistor, to enable a voltage of the gate of the MOS transistor to be greater than a first threshold.

In the driving circuit provided in embodiments of the disclosure, the direct current signal input by the external power supply apparatus through the first interface and the at least two PWM signals input based on the MCU through the second interface are superimposed and then rectified, and output to the gate of the MOS transistor in a charging path in the electronic device. The driving voltage generated by the driving circuit may be increased due to the at least two PWM signals input to the driving circuit through the second interface based on the MCU. Therefore, the voltage between the gate and the source between the MOS transistors may be increased, which may avoid reduced charging efficiency caused by a voltage VGS being too low, reduced fast charge current or exiting a fast charge mode.

Additional aspects and advantages of implementations of the present disclosure will be set forth in part in the following description, and in part will become obvious from the following description, or may be learned by practice of implementations of the disclosure.

### BRIEF DESCRIPTION OF THE DRAWINGS

In order to explain the technical solutions in embodiments of the present disclosure more clearly, the drawings described in embodiments will be briefly introduced below. Obviously, the drawings described as below are only some embodiments of the present disclosure. Those skilled in the art may obtain other drawings from these drawings without creative work.
FIG. 1 is a schematic diagram illustrating a diode in embodiments of the disclosure.
FIG. 2a and FIG. 2b are schematic diagrams respectively illustrating MOS transistors in embodiments of the disclosure;
FIG. 3 is a schematic diagram illustrating a fast charge path in embodiments of the disclosure;
FIG. 4 is a schematic diagram illustrating a structure of a fast charge path in embodiments of the disclosure;
FIG. 5 is a schematic diagram illustrating a relationship between a drain current and a drain-source voltage of a same MOS transistor at different gate-source voltages provided in embodiments of the disclosure;
FIG. 6 is a schematic diagram illustrating a driving circuit in an embodiment of the disclosure;
FIG. 7 is a schematic diagram illustrating a fast charge path in an embodiment of the disclosure;
FIG. 8 is a schematic diagram illustrating a fast charge path in another embodiment of the disclosure;
FIG. 9 is a schematic diagram illustrating a driving path in another embodiment of the disclosure;
FIG. 10 is a schematic diagram illustrating a driving circuit in yet another embodiment of the disclosure;
FIG. 11 is a schematic diagram illustrating a driving circuit in still another embodiment of the disclosure;
FIG. 12 is a schematic diagram illustrating a driving circuit in still another embodiment of the disclosure;
FIG. 13 is a schematic diagram illustrating a driving circuit in still another embodiment of the disclosure;
FIG. 14 is a schematic diagram illustrating a driving circuit in still another embodiment of the disclosure;
FIG. 15 is a schematic diagram illustrating a fast charge path in yet another embodiment of the disclosure;
FIG. 16 is a schematic diagram illustrating a fast charge path in still another embodiment of the disclosure;
FIG. 17 is a schematic diagram illustrating a PWM signal in an embodiment of the disclosure;
FIG. 18 is a schematic diagram illustrating an electronic device in embodiments of the disclosure;
FIG. 19 is a flowchart illustrating a method for controlling charging in an embodiment of the disclosure;
FIG. 20 is a flowchart illustrating a method for controlling charging in another embodiment of the disclosure;
FIG. 21 is a flowchart illustrating a method for controlling charging in yet another embodiment of the disclosure;
FIG. 22 is a schematic diagram illustrating a structure of a wired charging system in an embodiment of the disclosure; and
FIG. 23 is a schematic diagram illustrating a structure of a wired charging system in another embodiment of the disclosure.

### DETAILED DESCRIPTION

The following describes the technical solutions in the embodiments of the disclosure with reference to the accompanying drawings in the embodiments of the disclosure, and obviously, the described embodiments are a part of the embodiments of the disclosure, rather than all of the embodiments. All other embodiments obtained by those skilled in the art based on the embodiments of the present disclosure without any creative efforts shall be within the protection scope of the present disclosure.

In order to understand the present disclosure more clearly, working principles of a diode and a MOS transistor in the embodiments of the disclosure are briefly introduced, which facilitates subsequent understanding of the solution of the present disclosure. However, it should be understood that the following description is merely for a better understanding of the present disclosure, which should not be particularly limited in the present disclosure.

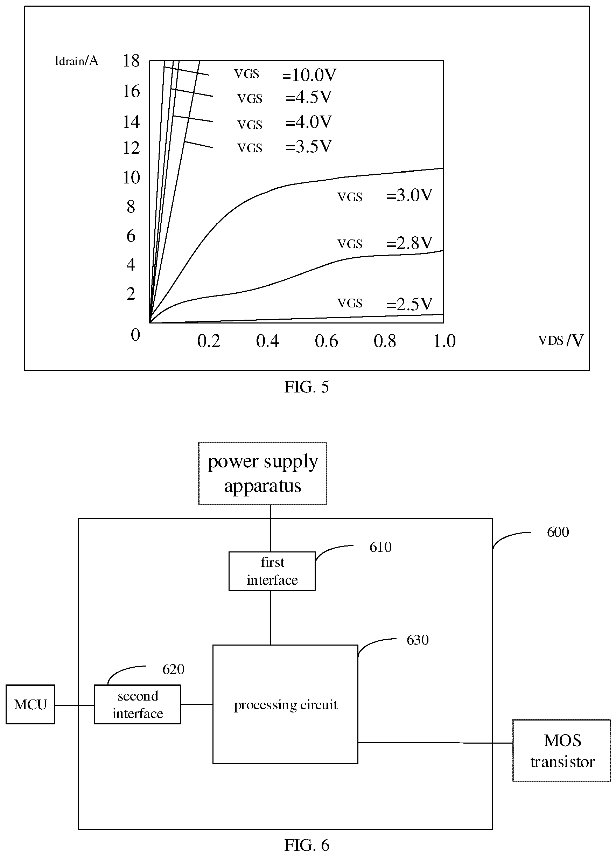

Referring to FIG. 6, a driving circuit 610 is applied to an electronic device, and the electronic device further includes a MOS transistor and a micro-controller unit (MCU). The driving circuit 610 includes: a first interface 610 connected to an external power supply apparatus, configured to receive a direct current signal input by the external power supply apparatus; a second interface 620 connected to the MCU, configured to receive at least two pulse width modulated PWM signals input by the MCU; and a processing circuit 630 connected to the first interface 610 and the second interface 620 respectively, configured to acquire a first direct current signal by superimposing and rectifying the direct current signal and the at least two PWM signals, and to output the first direct current signal to a gate of the MOS transistor to enable a voltage of the gate of the MOS transistor to be greater than a first threshold.

Referring to FIG. 6, in some implementations, the processing circuit 630 is further configured to: acquire a first PWM signal by superimposing the direct current signal and one of the at least two PWM signals, and acquire a second direct current signal by rectifying the first PWM signal; acquire the first direct current signal by superimposing and rectifying the second direct current signal and the remaining PWM signal in the at least two PWM signals.

Referring to FIG. 6, in some implementations, the processing circuit 630 is further configured to: filter the second direct current signal to acquire the filtered second direct current signal; acquire the first direct current signal by superimposing and rectifying the filtered second direct current signal and the remaining PWM signal in the at least two PWM signals .

Referring to FIG. 6, in some implementations, the processing circuit 630 is further configured to: acquire a first PWM signal by superimposing the direct current signal and one of the at least two PWM signals; acquire a third direct current signal by rectifying the remaining PWM signal in the at least two PWM signals; acquire the first direct current signal by superimposing and rectifying the third direct current signal and the first PWM signal.

Referring to FIG. 6, in some implementations, the processing circuit 630 is further configured to: filter the third direct current signal to acquire the filtered third direct current signal; acquire the first direct current signal by superimposing and rectifying the filtered third direct current signal and the first PWM signal.

Referring to FIG. 6, in some implementations, the processing circuit 630 is further configured to: filter the direct current signal input by the external power supply apparatus through the first interface 610.

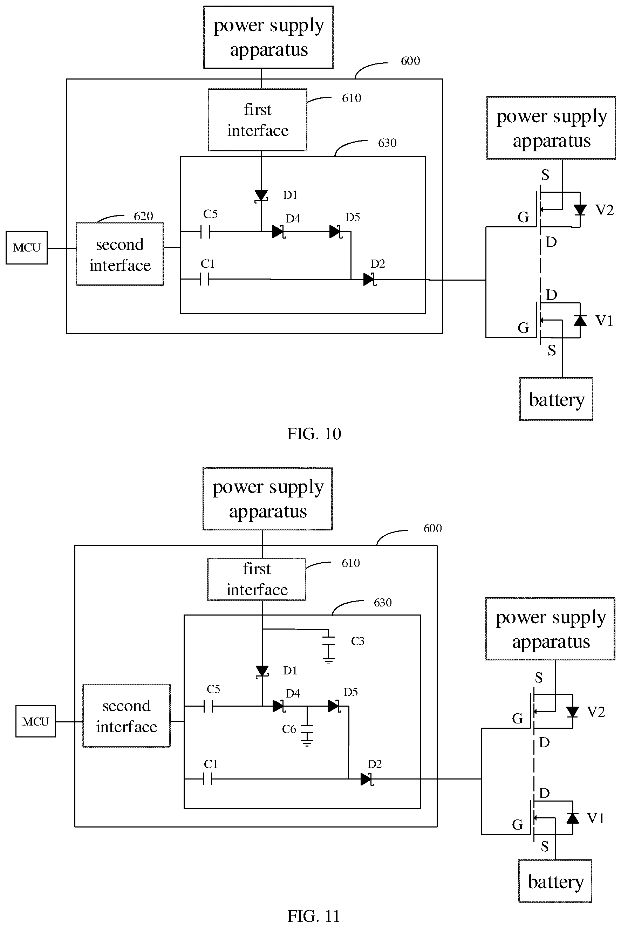

Referring to FIG. 11, in some implementations, the processing circuit 630 includes a capacitor C5, a capacitor C1, a diode D4 and a diode D2. One end of the capacitor C5 is connected to the second interface 620; one end of the capacitor C1 is connected to the second interface 620; an anode of the diode D4 is connected to the first interface 610 and the other end of the capacitor C5 respectively, and a cathode of the diode D4 is connected to the other end of the capacitor C1, the diode D4 being configured to rectify the first PWM signal to acquire the second direct current signal; an anode of the diode D2 is connected to a cathode of the diode D4 and the other end of the capacitor C1 respectively, and the cathode of the diode D2 is connected to a gate of a MOS transistor V1 and a gate of a MOS transistor V2, the diode D2 being configured to acquire the first direct current signal by rectifying a signal obtained by superimposing the second direct current signal and the remaining PWM signal output by the MCU. The capacitor C5 is configured to remove a direct current component from one of the at least two PWM signals before one of the at least two PWM signals is superimposed, and the capacitor C1 is configured to remove a direct current component from the remaining PWM signal in the at least two PWM signals before the remaining PWM signal in the at least two PWM signals is superimposed.

Referring to FIG. 11, in some implementations, the processing circuit 630 further includes a diode D1 and a diode D5. An anode of the diode D1 is connected to the first interface 610 and a cathode of the diode D1 is connected to the other end of the capacitor C5; an anode of the diode D5 is connected to a cathode of the diode D4, and a cathode of the diode D5 is connected to the other end of the capacitor C1.

Referring to FIG. 11, in some implementations, the processing circuit 630 further includes a diode D3 and a diode D6. One end of the capacitor C3 is connected to the first interface 610, and the other end of the capacitor C3 is grounded, the capacitor C3 being configured to filter the direct current signal output from the first interface 610; one end of the capacitor C6 is connected to a cathode of the diode D4, and the other end of the capacitor C6 is grounded, the capacitor C6 being configured to filter the second direct current signal output from the diode D4.

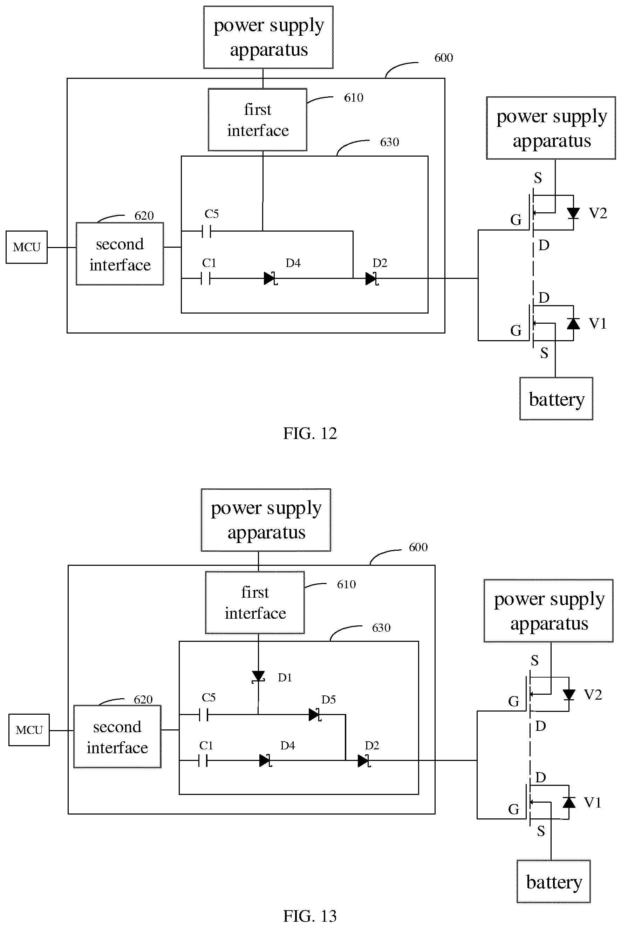

Referring to FIG. 12, in some implementations, the processing circuit 630 includes a capacitor C5, a capacitor C1, a diode D4 and a diode D2. One end of the capacitor C5 is connected to the second interface 620; one end of the capacitor C1 is connected to the second interface 620; an anode of the diode D4 is connected to the other end of the capacitor C1, and a cathode of the diode D4 is connected to the first interface 610 and the other end of the capacitor C5, the diode D4 being configured to acquire the third direct current signal by rectifying the remaining PWM signal in the at least two PWM signals; an anode of the diode D2 is connected to a cathode of the diode D4, the first interface 610 and the other end of the capacitor C5 respectively, and the cathode of the diode D2 is connected to a gate of a MOS transistor V1 and a gate of a MOS transistor V2, the diode D2 being configured to rectify a signal obtained by superimposing the third direct current signal and the first PWM signal to acquire the first direct current signal. The capacitor C5 is configured to remove a direct current component from one of the at least two PWM signals before one of the at least two PWM signals is superimposed, and the capacitor C1 is configured to remove a direct current component from the remaining PWM signal in the at least two PWM signals before the remaining PWM signal in the at least two PWM signals is superimposed.

Referring to FIG. 13, in some implementations, the processing circuit 630 further includes a diode D1 and a diode D5. An anode of the diode D1 is connected to the first interface 610 and a cathode of the diode D1 is connected to the other end of the capacitor C5; an anode of the diode D5 is connected to the other end of the capacitor C5 and a cathode of the diode D1, and a cathode of the diode D5 is connected to a cathode of the diode D4.

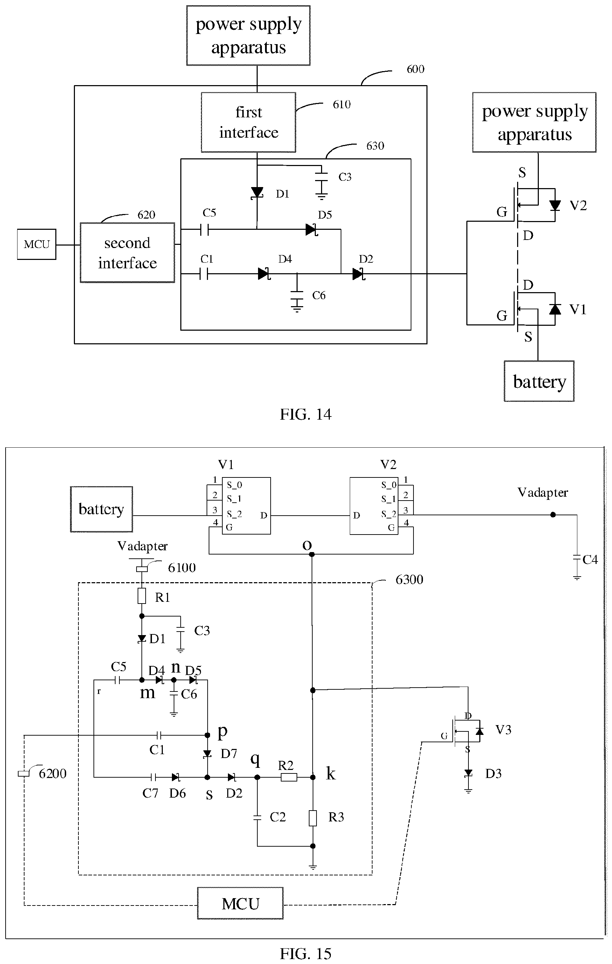

Referring to FIG. 14, in some implementations, the processing circuit 630 further includes a capacitor C3 and a capacitor C6. One end of the capacitor C3 is connected to the first interface 610, and the other end of the capacitor C3 is grounded, the capacitor C3 being configured to filter the direct current signal output from the first interface 610; one end of the capacitor C6 is connected to the cathode of the diode D4, and the other end of the capacitor C6 is grounded, the capacitor C6 being configured to filter the third direct current signal output from the diode D4.

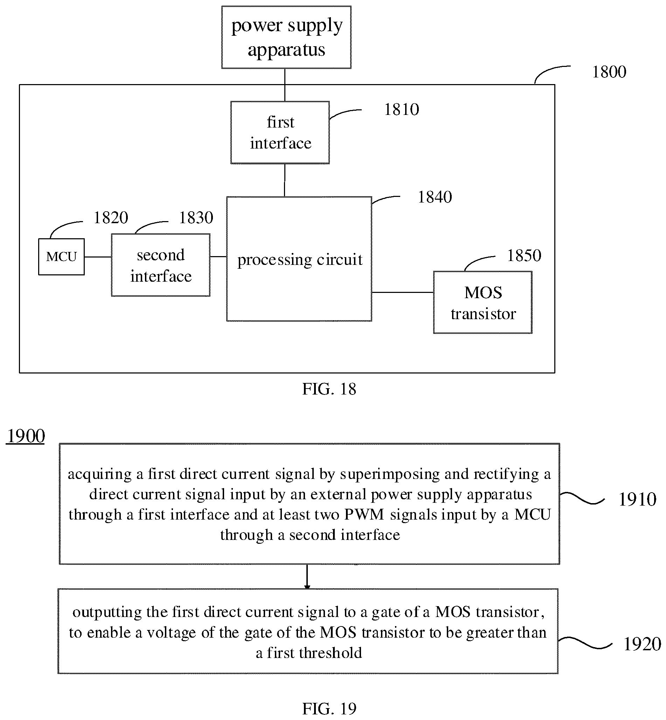

Referring to FIG. 6 and FIG. 18, an electronic device 1800 in implementations of the disclosure includes a first interface 1810, a micro-controller unit (MCU) 1820, a second interface 1830, a processing circuit 1840 and a MOS transistor 1850. The first interface 1810 connected to an external power supply apparatus is configured to receive a direct current signal input by the external power supply apparatus. The second interface 1830 connected to the MCU 1820 is configured to receive at least two pulse width modulated PWM signals input by the MCU 1820. The processing circuit 1840 connected to the first interface 610 and the second interface 620 respectively is configured to acquire a first direct current signal by superimposing and rectifying the direct current signal and the at least two PWM signals and output the first direct current signal to a gate of the MOS transistor, to enable a voltage of the gate of the MOS transistor to be greater than a first threshold.

Referring to FIG. 6, in some implementations, the processing circuit 630 is further configured to: acquire a first PWM signal by superimposing the direct current signal and one of the at least two PWM signals and acquire a second direct current signal by rectifying the first PWM signal; acquire the first direct current signal by superimposing and rectifying the second direct current signal and a remaining PWM signal in the at least two PWM signals.

Referring to FIG. 6, in some implementations, the processing circuit 630 is further configured to: filter the second direct current signal to acquire the filtered second direct current signal; acquire the first direct current signal by superimposing and rectifying the filtered second direct current signal and the remaining PWM signal in the at least two PWM signals.

Referring to FIG. 6, in some implementations, the processing circuit 630 is further configured to: acquire a first PWM signal by superimposing the direct current signal and one of the at least two PWM signals; acquire a third direct current signal by rectifying the remaining PWM signal in the at least two PWM signals; and acquire a first direct current signal by superimposing and rectifying the third direct current signal and the first PWM signal.

Referring to FIG. 6, in some implementations, the processing circuit 630 is further configured to: filter the third direct current signal to acquire a filtered third direct current signal; acquire the first direct current signal by superimposing and rectifying the filtered third direct current signal and the first PWM signal.

Referring to FIG. 6, in some implementations, the processing circuit 630 is further configured to: filter the direct current signal input by the external power supply apparatus through the first interface 610.

Referring to FIG. 11, in some implementations, the processing circuit 630 includes a capacitor C5, a capacitor C1, a diode D4 and a diode D2. One end of the capacitor C5 is connected to the second interface 620; one end of the capacitor C1 is connected to the second interface 620; an anode of the diode D4 is connected to the first interface 610 and the other end of the capacitor C5 respectively, and a cathode of the diode D4 is connected to the other end of the capacitor C1, the diode D4 being configured to rectify the first PWM signal to acquire the second direct current signal; an anode of the diode D2 is connected to a cathode of the diode D4 and the other end of the capacitor C1 respectively, and the cathode of the diode D2 is connected to a gate of a MOS transistor V1 and a gate of a MOS transistor V2, the diode D2 being configured to rectify the signal obtained by superimposing the second direct current signal and the remaining PWM signal output by the MCU to acquire the first direct current signal. The capacitor C5 is configured to remove a direct current component from one of the at least two PWM signals before one of the at least two PWM signals is superimposed, and the capacitor C1 is configured to remove a direct current component from the remaining PWM signal in the at least two PWM signals before the remaining PWM signal in the at least two PWM signals is superimposed.

Referring to FIG. 11, in some implementations, the processing circuit 630 further includes a diode D1 and a diode D5. An anode of the diode D1 is connected to the first interface 610 and a cathode of the diode D1 is connected to the other end of the capacitor C5; an anode of the diode D5 is connected to a cathode of the diode D4, and a cathode of the diode D5 is connected to the other end of the capacitor C1.

Referring to FIG. 11, in some implementations, the processing circuit 630 further includes a capacitor C3 and a capacitor C6. One end of the capacitor C3 is connected to the first interface 610, and the other end of the capacitor C3 is grounded, the capacitor C3 being configured to filter the direct current signal output from the first interface 610; one end of the capacitor C6 is connected to a cathode of the diode D4, and the other end of the capacitor C6 is grounded, the capacitor C6 being configured to filter the second direct current signal output from the diode D4.

Referring to FIG. 12, in some implementations, the processing circuit 630 includes a capacitor C5, a capacitor C1, a diode D4 and a diode D2. One end of the capacitor C5 is connected to the second interface 620; one end of the capacitor C1 is connected to the second interface 620; an anode of the diode D4 is connected to the other end of the capacitor C1, and a cathode of the diode D4 is connected to the first interface 610 and the other end of the capacitor C5, the diode D4 being configured to rectify the remaining PWM signal in the at least two PWM signals to acquire a third direct current signal; an anode of the diode D2 is connected to a cathode of the diode D4, the first interface 610 and the other end of the capacitor C5 respectively, and the cathode of the diode D2 is connected to a gate of a MOS transistor V1 and a gate of a MOS transistor V2, the diode D2 being configured to rectify a signal obtained by superimposing the third direct current signal and the first PWM signal to acquire the first direct current signal. The capacitor C5 is configured to remove a direct current component from one of the at least two PWM signals before one of the at least two PWM signals is superimposed, and the capacitor C1 is configured to remove a direct current component from the remaining PWM signal in the at least two PWM signals before the remaining PWM signal in the at least two PWM signals is superimposed.

Referring to FIG. 13, in some implementations, the processing circuit 630 further includes a diode D1 and a diode D5. An anode of the diode D1 is connected to the first interface 610 and a cathode of the diode D1 is connected to the other end of the capacitor C5; an anode of the diode D5 is connected to the other end of the capacitor C5 and the cathode of the diode D1, and a cathode of the diode D5 is connected to the cathode of the diode D4.

Referring to FIG. 14, in some implementations, the processing circuit 630 further includes a capacitor C3 and a capacitor C6. One end of the capacitor C3 is connected to the first interface 610, and the other end of the capacitor C3 is grounded, the capacitor C3 being configured to filter the direct current signal output from the first interface 610; one end of the capacitor C6 is connected to the cathode of the diode D4, and the other end of the capacitor C6 is grounded, the capacitor C6 being configured to filter the third direct current signal output from the diode D4.

Referring to FIG. 19, the method 1900 for controlling charging in the implementation includes the following blocks. At block 1910, a first direct current signal is acquired by superimposing and rectifying the direct current signal input by the external power supply apparatus through the first interface and the at least two PWM signals input by the MCU through the second interface. At block 1920, the first direct current signal is output to a gate of the MOS transistor, to enable a voltage of the gate of the MOS transistor to be greater than a first threshold.

In some implementations, the block 1910 includes: acquiring a first PWM signal by superimposing the direct current signal input by the external power supply apparatus through the first interface and one of the at least two PWM signals, and acquiring a second direct current signal by rectifying the first PWM signal; acquiring the first direct current signal by superimposing and rectifying the second direct current signal and the remaining PWM signal in the at least two PWM signals.

Referring to FIG. 19, in some implementations, the method 1900 further includes: filtering the second direct current signal to acquire the filtered second direct current signal. Acquiring the first direct current signal by superimposing and rectifying the second direct current signal and the remaining PWM signal in the at least two PWM signals includes: acquiring the first direct current signal by superimposing and rectifying the filtered second direct current signal and the remaining PWM signal in the at least two PWM signals.

Referring to FIG. 19, in some implementations, the block 1910 includes: acquiring a first PWM signal by superimposing the direct current signal input by the external power supply apparatus through the first interface and one of the at least two PWM signals; acquiring a third direct current signal by rectifying the remaining PWM signal in the at least two PWM signals, and acquiring the first direct current signal by superimposing and rectifying the third direct current signal and the first PWM signal.

Referring to FIG. 19, in some implementations, the method 1900 further includes: filtering the third direct current signal to acquire the filtered third direct current signal; acquiring the first direct current signal by superimposing and rectifying the third direct current signal and the first PWM signal includes: acquiring the first direct current signal by superimposing and rectifying the filtered third direct current signal and the first PWM signal.

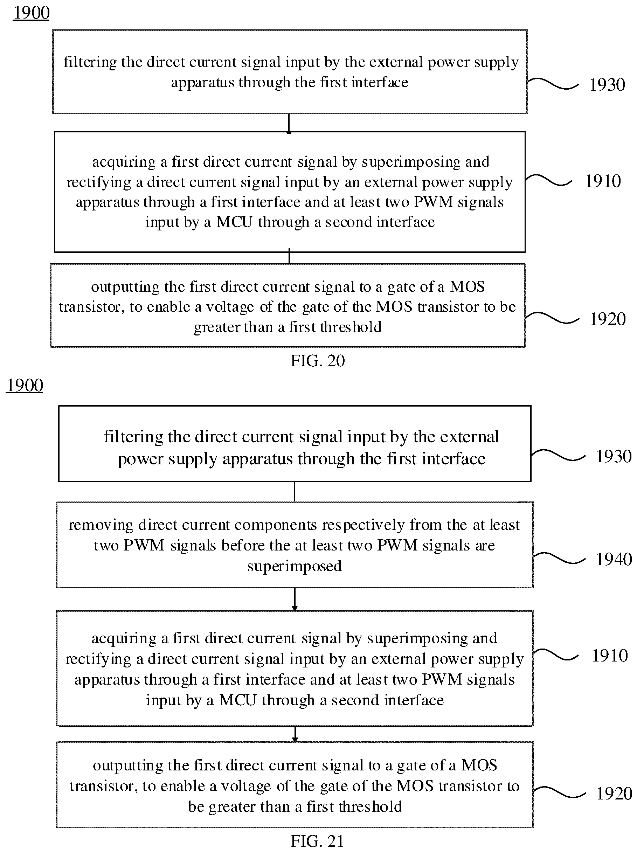

Referring to FIG. 20, in some implementations, the method 1900 may further include block 1930: filtering the direct current signal input by the external power supply apparatus through the first interface.

Referring to FIG. 21, in some implementations, the method 1900 may further include block 1940: removing direct current components respectively from the at least two PWM signals before the at least two PWM signals are superimposed.

Referring to FIG. 19, a computer readable storage medium of the present disclosure has executable computer instructions stored thereon, and the executable computer instructions are configured to execute any of the above method 1900. The executable computer instructions are configured to execute the following blocks: acquiring a first direct current signal by superimposing and rectifying the direct current signal input by the external power supply apparatus through the first interface and the at least two PWM signals input by the MCU through the second interface; and outputting the first direct current signal to a gate of the MOS transistor, to enable a voltage of the gate of the MOS transistor to be greater than a first threshold.

In some implementations, the executable computer instructions are configured to execute the following blocks: acquiring a first PWM signal by superimposing the direct current signal input by the external power supply apparatus through the first interface and one of the at least two PWM signals, and acquiring a second direct current signal by rectifying the first PWM signal; acquiring the first direct current signal by superimposing and rectifying the second direct current signal and the remaining PWM signal in the at least two PWM signals.

In some implementations, the executable computer instructions are configured to execute the following blocks: filtering the second direct current signal to acquire the filtered second direct current signal; acquiring the first direct current signal by superimposing and rectifying the filtered second direct current signal and the remaining PWM signal in the at least two PWM signals.

In some implementations, the executable computer instructions are configured to execute the following blocks: acquiring a first PWM signal by superimposing the direct current signal input by the external power supply apparatus through the first interface and one of the at least two PWM signals; acquiring a third direct current signal by rectifying the remaining PWM signal in the at least two PWM signals, and acquiring the first direct current signal by superimposing and rectifying the third direct current signal and the first PWM signal.

In some implementations, the executable computer instructions are configured to execute the following blocks: filtering the third direct current signal to acquire the filtered third direct current signal; acquiring the first direct current signal by superimposing and rectifying the filtered third direct current signal and the first PWM signal.

In some implementations, the executable computer instructions are configured to execute the following blocks: filtering the direct current signal input by the power supply apparatus through the first interface.

In some implementations, the executable computer instructions are configured to execute the following blocks: removing direct current components respectively from the at least two PWM signals before the at least two PWM signals are superimposed.

Referring to FIG. 19, a computer program product in the disclosure includes computer instructions, caused a computer to execute any of the above methods 1900. The computer program instructions cause the computer to execute the following blocks: acquiring a first direct current signal by superimposing and rectifying the direct current signal input by the external power supply apparatus through the first interface and the at least two PWM signals input by the MCU through the second interface; and outputting the first direct current signal to a gate of the MOS transistor, to enable a voltage of the gate of the MOS transistor to be greater than a first threshold.

In some implementations, the executable computer instructions cause the computer to execute the following blocks: acquiring a first PWM signal by superimposing the direct current signal input by the external power supply apparatus through the first interface and one of the at least two PWM signals, and acquiring a second direct current signal by rectifying the first PWM signal; acquiring the first direct current signal by superimposing and rectifying the second direct current signal and the remaining PWM signal in the at least two PWM signals.

In some implementations, the executable computer instructions cause the computer to execute the following blocks: filtering the second direct current signal to acquire the filtered second direct current signal; acquiring the first direct current signal by superimposing and rectifying the filtered second direct current signal and the remaining PWM signal in the at least two PWM signals.

In some implementations, the executable computer instructions cause the computer to execute the following blocks: acquiring a first PWM signal by superimposing the direct current signal input by the external power supply apparatus through the first interface and one of the at least two PWM signals; acquiring a third direct current signal by rectifying the remaining PWM signal in the at least two PWM signals, and acquiring the first direct current signal by superimposing and rectifying the third direct current signal and the first PWM signal.

In some implementations, the executable computer instructions cause the computer to execute the following blocks: filtering the third direct current signal to acquire the filtered third direct current signal; acquiring the first direct current signal by superimposing and rectifying the filtered third direct current signal and the first PWM signal.

In some implementations, the executable computer instructions cause the computer to execute the following blocks: filtering the direct current signal input by the power supply apparatus through the first interface.

In some implementations, the executable computer instructions cause the computer to execute the following blocks: removing direct current components respectively from the at least two PWM signals before the at least two PWM signals are superimposed.

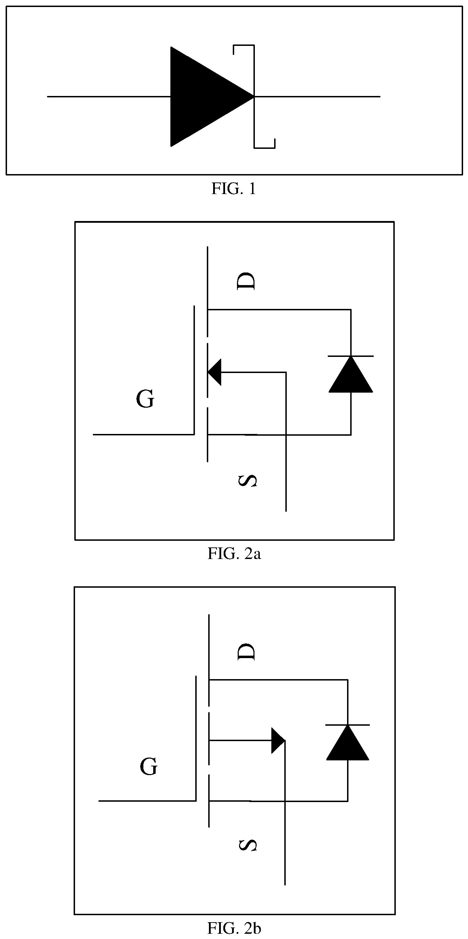

FIG. 1 is a schematic diagram of a Schottky diode. A Schottky diode is manufactured based on a principle of metal and semiconductor contacting to form a metal-semiconductor junction, rather than based on a principle of P-type semiconductor and N-type semiconductor contacting to form a PN junction. The Schottky diode has advantages such as a high switching frequency and a low forward voltage drop, etc.

A MOS transistor is a metal-oxide-semiconductor field effect transistor, or referred to as a metal-insulator, a semiconductor. The MOS transistor includes an N-channel MOS transistor and a P-channel MOS transistor. FIG. 2A and FIG. 2B are schematic diagrams respectively illustrating an N-channel MOS transistor and a P-channel MOS transistor, where D is a drain, S is a source, and G is a gate, and an arrow in the middle represents a substrate. The MOS transistor may include an N-channel MOS transistor and a P-channel MOS transistor.

Taking the N-channel MOS transistor as an example, when a voltage across the gate and the source is at a high level, that is, VGS > 0, a channel between the drain and the source is turned on, at this time, a resistance between the drain and the source is equivalent to a small resistance, and a current flows from the drain to the source; when the voltage between the gate and the source is at a low level, that is, VGS < 0, the channel between the drain and the source is turned off, at this time, a resistance between the drain and the source is equivalent to a large resistance , and the current may not flow between the drain and the source.

Conversely, for a P-channel MOS transistor, when the voltage between the gate and the source is at a low level, that is, VGS < 0, a channel between the drain and the source is turned on, at this time, a resistance between the drain and the source is equivalent to a small resistance , and the current flows from the source to the drain; when the voltage between the gate and the source is at a high level, that is, VGS > 0, the channel between the drain and the source is turned off, at this time, a resistance between the drain and the source is equivalent to a large resistance, and the current may not flow between the drain and the source.

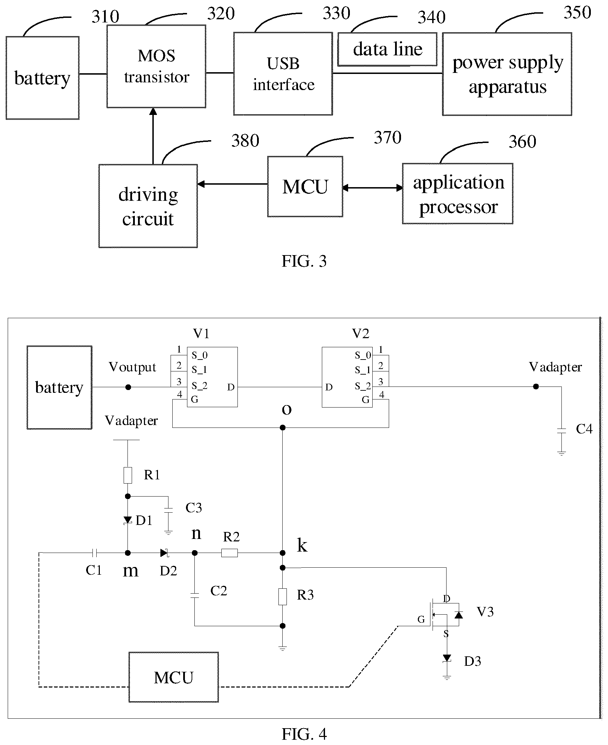

FIG. 3 is a schematic diagram illustrating a fast charge path in embodiments of the disclosure. The schematic diagram of fast charge path may include: a battery 310, a MOS transistor 320, a universal serial bus interface (USB interface) 330, a data line 340, a power supply apparatus 350, an application processor (AP) 360, a micro-controller unit (MCU) 370, and a driving circuit 380. The power supply apparatus 350 in the embodiment of the disclosure may be an adapter, a mobile power supply, etc. The MCU 370 in the embodiments may control connection or disconnection of the fast charge path, and may also output multiple pulse width modulation (PWM) signals. In the embodiments, the AP360 may control the connection or disconnection of the fast charge path. In some embodiments, the MCU 370 and the AP 360 may be the same one.

Taking a mobile phone as an example, a mobile phone is provided with the battery 310 and the MOS transistor 320. The power supply apparatus 350 is connected to the mobile phone through a USB interface 330, and the USB interface 330 may be a Micro USB interface or a Type-C USB interface. A data line in the USB interface is configured for bidirectional communication between the power supply apparatus and the mobile phone. The data line may be a D+ line and/or a D-line in the USB interface, and the bidirectional communication may refer to information interaction between the power supply apparatus and the mobile phone each other, in which the MOS transistor, the driving circuit, the MCU and the AP may be located on a mainboard inside the mobile phone.

In the embodiments, the power supply apparatus 350 supports a normal charge mode and a fast charge mode, in which a charging speed of the fast charge mode is greater than a charging speed of the normal charge mode. A charging current of the fast charge mode is greater than a charging current of the normal charge mode and/or a charging voltage of the fast charge mode is higher than a charging voltage of the normal charge mode.

In general, the normal charge mode refers to that the power supply apparatus charges the battery in the electronic device by outputting a relatively small current value (typically less than 2.5A) or with a relatively small power (typically less than 15W). In the normal charge mode, it typically requires several hours to fill a battery with larger capacity (for example, a battery with a capacity of 3000 milliamps). In the fast charge mode, the power supply apparatus may charge the battery in the electronic device by outputting a relatively large current (typically greater than 2.5A, such as 4.5A, 5A or even higher) or with a relatively large power (typically greater than or equal to 15W). Compared with the normal charging mode, the power supply apparatus completely filling the battery with the same capacity in the fast charge mode may require an obviously shortened charging time and a faster charging speed. The fast charge mode may also be divided into a plurality of fast charge phases according to different impedances of a charging loop. As the impedance increases, the current in the fast charge phase decreases.

When fast charging is performed on the electronic device, a voltage of the gate of the metal oxide semiconductor (MOS) transistor in the charging loop is controlled by a driving voltage output by the driving circuit, however, the driving voltage output by the existing driving circuit is small, so that the impedance between the drain and the source of the MOS transistor is large when the MOS transistor is turned on, on one hand, causing serious heating of the MOS transistor and reduced charging efficiency, and on the other hand, causing too large impedance of the whole charging loop due to too large impedance when the MOS is turned on, thereby reducing a fast charge current or exiting a fast charge mode.

Taking a mobile phone as an example, in a process of charging the mobile phone in the fast charge mode, the mobile phone sends a battery voltage V1 close to the power supply end to the power supply apparatus in real time via D+ and/or D- signals on the data line, and the power supply apparatus may compare V1 with a voltage VO output by itself and then divide a charging current I to obtain an impedance R of a charging loop, that is, R = (V0-V1)/I. In some embodiments, the specific control method based on impedance may be shown in Table 1:

**Table 1**

| impedance of a loop | R≤R1 | R1<R≤R2 | R2<R≤R3 | R>R3 |
|---|---|---|---|---|
| fast charge current | I1 | I2 | I3 | exit fast charge |

When the impedance R of the charging loop is less than R1, the current is configured I1 for fast charge; when the impedance increases to a value satisfying R1<R≤R2, the current of the charging loop is reduced to I2 for fast charge (12< I1); when the impedance continues to increase to a value satisfying R2<R≤R3, the current of the charging loop is reduced to I3 for fast charge (I3< 12); when the impedance continues to increase to a value satisfying R>R3, the fast charge mode is exited, and the mobile phone is charged with the normal charge mode.

The MCU in embodiments of the disclosure may control turning on and turning off of the MOS transistor, thereby achieving entry and exit of the fast charge mode.

For brevity, in the following embodiments, the power supply apparatus in the disclosure is illustrated by taking an adapter as an example.

FIG. 4 is a schematic diagram illustrating a structure of a fast charge path. The MCU in the embodiments may achieve the entry and exit of fast charge by controlling levels of its output. Taking the N-channel MOS transistor as an example, when the MCU outputs a high level, since the voltage of the gate of the N-channel MOS transistor V3 is lower than the voltage of the source, the MOS transistor V3 is in a turn-on state, and a voltage Vbus output by the adapter and a voltage of a PWM signal output by the MCU are grounded through the MOS transistor V3. When the MCU outputs a low level, since the voltage of the gate of the N-channel MOS transistor V3 is higher than the voltage of the source, the MOS transistor V3 is in a turn-off state, at this time, the voltage Vbus output by the adapter charges a battery.

When the MCU outputs the low level, the MOS transistor V3 is in the turn-off state, the voltage Vbus output by the adapter reaches a position between the diode D1 and the diode D2 through the resistor R1 and the diode D1. A voltage Vclk of a signal controlled and output by the MCU is added to the position between the diode D1 and the diode D2 through charging and discharging on the capacitor C1. Since the resistor R3 a large impedance, a current flowing through the resistors R1, R2 and R3 is very small, and a voltage drop of the resistors R1, R2 and R3 is very small, in this case, a voltage of the position between the diode D1 and the diode D2 is Vm = (Vbus-Vd) + Vclk, and then is rectified by the diode D2, the voltage of a position between the diode D2 and the resistor R2 is Vn = (Vbus-2Vd) + Vclk, where Vd denotes a voltage drop across the diode D1 or the diode D2.

The diode D1 in the above circuit may avoid reverse flow of current, such that electric leakage caused by an increase of the voltage Vm at m point between the diode D1 and the diode D2 may be avoided. That is, since the voltage Vm at m point between the diode D1 and the diode D2 is greater than the voltage output by the adapter, which may cause the current to flow reversely the resistor R1 and to be transmitted to the adapter, so the diode D1 may prevent reverse charging of current. The diode D2 may rectify an alternating current into a direct current. Since the voltage Vbus output by the adapter is a DC (direct current) voltage, the voltage Vclk of the signal controlled and output by the MCU is a voltage of an alternating current PWM signal. When the voltage Vbus output by the adapter and the voltage Vclk of the signal controlled and output by the MCU reach a position between the diodes D1 and D2, the voltage presented is also an alternating current voltage, therefore, the alternating current is rectified into the direct current after rectification of the diode D2.

In the above process, since the resistor R2 has a large impedance, the current flowing through the resistor R2 is small, and the voltage drop across the resistor R2 is also very small, For the MOS transistor V1 and the MOS transistor V2, the voltage of the gate of each MOS transistor is substantially equal to the voltage Vn at n point between the diode D2 and the resistor R2, that is, VG = Vn = (Vbus-2Vd) + Vclk. For the MOS transistor V2, the voltage between the gate and the source is VGS2=Vclk-2Vd. For the MOS transistor V1, the voltage between the gate and the source is VGS1= (Vbus-2Vd) +Vclk -Vbat, where Vbat denotes an output voltage of the MOS transistor V1.

For the circuit in FIG. 4, the voltage difference between the gate and the source of the MOS transistor V2 is VGS2=Vclk-2Vd. Since the voltage Vclk is controlled by the fast charge MCU, in general, a voltage supplying power for a MCU of the mobile phone is only about 4V, and the voltage Vclk generated by the MCU is only about 4V, the voltage VGS2 applied between the gate and the source of the MOS transistor V2 is usually lower than 4V. When the voltage VGS between the gate and the source on the MOS transistor is relatively low, the impedance RDS between the drain and the source of the MOS transistor in the charging loop is relatively large. Specifically, for the same MOS transistor, under different VGSs, the relationship between current ID of the drain and the voltage VDS between the drain and the source may be as illustrated in FIG. 5.

As can be seen from FIG. 5, for the same MOS transistor, the lower the VGS, the greater the impedance RDS between the drain and the source when the MOS transistor is turned on. In particular, when the VGS is too low, the impedance RDS when the MOS transistor is turned on is too large. Therefore, it can be known from P=I2^{∗}R, a part of electric quantity is consumed on the MOS transistor in the form of heat, resulting in serious heating of the MOS transistor and a decrease in charging efficiency. In addition, since the impedance RDS of the MOS transistor is too large when the MOS transistor is turned on, caused the impedance of the entire charging loop to be too large, a fast charge current may be controlled reduced or a fast charge mode may be exited according to the control method of the impedance in Table 1.

Therefore, the following solution is provided in embodiments of the disclosure, which may avoid a reduced charging efficiency caused due to the voltage VGS being too low, and may avoid rapidly reducing a fast charge current or exiting a fast charge mode caused by the overlarge impedance when the MOS transistor is turned on.

In combination with FIG. 6, the driving circuit in embodiments of the disclosure is described.

The driving circuit 600 in embodiments of the disclosure includes a first interface 610, a second interface 620 and a processing circuit 630.

The first interface 610 connected to an adapter is configured to receive a direct current signal input by the adapter.

The second interface 620 connected to the MCU is configured to receive at least two pulse width modulated PWM signals input by the MCU.

In embodiments of the disclosure, the MCU is a micro controller unit. The MCU may control turning on or turning off of other components in the electronic device, for example, control the MOS transistor to be turned on or turned off via a level signal output from a pin of the MCU.

The PWM signal in embodiments of the disclosure is a signal output by the MCU, and may be a square signal or other signals. A duty cycle of the PWM signal in embodiments of the disclosure may be 50%, 20%, etc., which will not be limited here.

The processing circuit 630 connected to the first interface 610 and the second interface 620 respectively is configured to acquire a first direct current signal by superimposing and rectifying the direct current signal and the at least two PWM signals, and output the first direct current signal to a gate of the MOS transistor, to enable the voltage of the gate of the MOS transistor to be greater than a first threshold.

In embodiments of the disclosure, the at least two PWM signals received through the second interface 620 are alternating current signals. When the direct current signal input by the adapter through the first interface 610 is superimposed with the at least two PWM signals, the superimposed PWM signals are also the alternating current signals. Compared with the at least two PWM signals input by the second interface, frequency of the superimposed PWM signal does not change, and amplitude of that increases.

In embodiments of the disclosure, the at least two PWM signals received from the MCU through the second interface 620 may be two PWM signals input by a same pin of the MCU through changing of a driving circuit, or may be at least two PWM signals input by different pins of the MCU directly through the second interface 620. It may be understood that, when the at least two PWM signals are the at least two PWM signals input by different pins of the MCU directly through the second interface 620, frequencies of the PWM signals output by the two pins are the same.

The form of the processing circuit 630 is not limited in embodiments of the disclosure. The circuit that may superimpose and rectify the direct current signal and the at least two PWM signals and output the first direct current signal may be applied in embodiments of the disclosure.

In embodiments of the disclosure, the processing circuit 630 acquires the first direct current signal by superimposing and rectifying the direct current signal input by the adapter and the at least two PWM signals, and outputs the acquired first direct current signal to the gate of the MOS transistor in the electronic device, to enable the voltage of the gate of the MOS transistor to be greater than the first threshold.

In some embodiments, the first threshold may be 8.6V. The voltage of the gate of the MOS transistor being greater than 8.6V may be applied in embodiments of the disclosure.

It should be understood that, numerical values in embodiments of the disclosure are merely examples, and may also be other numerical values, which should not be specifically limited in the disclosure.

A structure with a rectifying function in the processing circuit 630 in embodiments of the present disclosure may be a Schottky diode, or may be a circuit having a rectifying function, which is not specifically limited in the present disclosure. Any structure that may rectify the PWM signal into the direct current signal may be applied in the embodiments of the present disclosure. For example, the circuit with the rectifying function may be a rectifying circuit (such as half-wave rectification, full-wave rectification, bridge rectification, etc.), or may be other types of rectifying circuits.

The driving circuit 600 in embodiments of the disclosure may be the driving circuit 380 in FIG. 3.

In the driving circuit 600 provided in embodiments of the disclosure, the direct current signal input by the adapter through the first interface 610 and the at least two PWM signals input based on the MCU through the second interface 620 are superimposed and then rectified, and output to the gate of the MOS transistor in a charging path in the electronic device. The driving voltage generated by the driving circuit may be increased due to the at least two PWM signals input to the driving circuit through the second interface based on the MCU. Therefore, the voltage between the gate and the source of the MOS transistors may be increased, which may avoid reducing charging efficiency caused by a voltage VGS being too low, and rapidly reducing fast charge current or exiting a fast charge mode caused by a impedance being too large when the MOS transistor is turned on.

It should be understood that, since superimposition of signals having a common node is not a simple addition of voltage values, each times for superimposing the signals in embodiments of the disclosure is the superimposing the direct current signal with the PWM signal or superimposing the PWM signal with the PWM signal. For superimposing the PWM signal with the PWM signal. Considering influence of each PWM signal on signals, the PWM signal with the PWM signal are kept at a same frequency when being superimposed, and a bandwidth of a high level of one PWM signal is less than a bandwidth of a high level of another PWM signal.

In some embodiments, the processing circuit 630 is further configured to acquire a first PWM signal by superimposing the direct current signal and one of the at least two PWM signals and acquire a second direct current signal by rectifying the first PWM signal; acquire the first direct current signal by superimposing and rectifying the second direct current signal and the remaining PWM signal in the at least two PWM signals.

In embodiments of the disclosure, the processing circuit 630 may acquire the first PWM signal by superimposing the direct current signal input by the adapter through the first interface 610 and one of the at least two PWM signals input through the second interface 620 based on the MCU and acquire the second direct current signal by rectifying the first PWM signal, and then acquire a first direct current signal by superimposing and rectifying the second direct current signal and the remaining PWM signal in the at least two PWM signals, and output the first direct current signal to the gate of the MOS transistor on the charging path to increase the gate voltage of the MOS transistor.

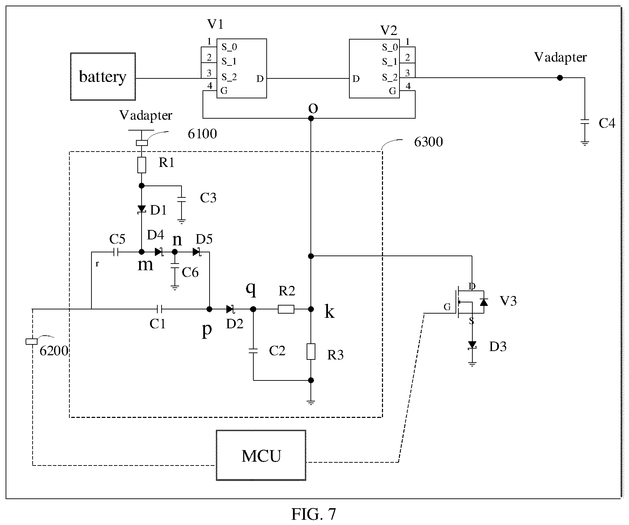

FIG. 7 is a schematic diagram illustrating a fast charge path in an embodiment of the disclosure. As can be seen from FIG. 7, the first PWM signal is acquired by superimposing the direct current signal input by the adapter and one of the at least two PWM signals input based on the MCU at m point, and is rectified by the second rectifier D4 to acquire the second direct current signal, and the second direct current signal and the remaining PWM signal in the at least two PWM signals are superimposed at p point and a signal at t p point is rectified by the first rectifier D2 to acquire the first direct current signal.

Specifically, for the m point, the direct current signal input by the adapter and the PWM signal input by the MCU through the capacitor C5 are superimposed at the m point, at this time, the voltage at the m point is Vm = (Vbus-Vd) + Vclk, then through rectifying of the diode D4, the voltage at n point is Vn = (Vbus-2Vd) + Vclk, and then the voltage at n point reached to p point through the diode D5. The PWM signal based on the MCU through the capacitor C1 is superimposed with the direct current signal through the diode D5 at p point, at this time, the voltage at p point is Vp = (Vbus-3Vd) +2Vclk, and after rectifying of the diode D2, the voltage at q point is Vq = (Vbus-4Vd) +2Vclk, that is, the voltage of the gate of the MOS transistor V1 is Vo = Vq= (Vbus-4Vd) +2Vclk.

In general, a voltage drop of a diode is relatively small, typically may be 0.1 V to 0.2V, and the voltage Vclk of the signal output by the MCU is generally about 4V. For example, in an embodiment, when the voltage output by the adapter is 5V, the voltage of the signal output by the MCU is 4V, and the voltage across the diode is 0.2V, the voltage at o point, that is, the voltage of the gate of the MOS transistor V1 and the voltage of the gate of the MOS transistor each is VG = V2 = Vo = (Vbus-2Vd) + Vclk = 5-0.4 +4 = 8.6V In another embodiment, since a voltage of one PWM signal is added, as illustrated in FIG. 7, the voltage of the gate of the MOS transistor is VG = Vo = (Vbus-4Vd) +2Vclk=5-0.8+8=12.2V.

In this case, the voltage of the gate of the MOS transistor V1 increases Vincrease = Vclk-2Vd = 3.6V. Therefore, in the embodiments of the present disclosure, each of the voltage of the gate of the MOS transistor V1 and the voltage of the gate of the MOS transistor V2 may be increased, so as to reduce the impedance between the drain and the source of each MOS transistor when the MOS transistor V1 and the MOS transistor V2 are turned on, and further avoid reducing the current or exiting the fast charging mode due to the heating of the MOS transistor V1 and the MOS transistor V2 and an overlarge impedance of the charging loop.

Of course, in some embodiments, a voltage of a gate of the MOS transistor V1 and the MOS transistor V2 may also be increased by increasing a magnitude of the voltage Vclk of the signal controlled and output by the MCU, for example, the voltage of the signal output by the MCU may be controlled to 5V, that is, the voltage of the gate of the MOS transistor may be increased, so as to reduce the impedance between the drain and the source of each MOS transistor when the MOS transistor V1 and the MOS transistor V2 are turned on, and further avoid reducing the current or exiting the fast charging mode due to the heating of the MOS transistor V1 and the MOS transistor V2 and the overlarge impedance of the charging loop.

Or, in some embodiments, the voltage of the gate of the MOS transistor V1 and the voltage of the gate of the MOS transistor V2 may also be increased by reducing the voltage drop across the diodes D1, D2, D4 or D5, so as to reduce the impedance between the drain and the source of each MOS transistor when the MOS transistor V1 and the MOS transistor V2 are turned on, and further avoid reducing the current or exiting the fast charging mode due to the heating of the MOS transistor V1 and the MOS transistor V2 and the overlarge impedance of the charging loop.

The second direct current signal is acquired by rectifying the first PWM signal. Since the direct current signal acquired via rectification may have a relatively large pulsatility (ripple), that is, there may be small peaks and valleys, the direct current signal acquired via rectification requires to be filtered, and the signal obtained by filtering is relatively smooth, and quality of voltage is high.

In some embodiments, the processing circuit 630 is further configured to: filter the second direct current signal to acquire the filtered second direct current signal; acquire the first direct current signal by superimposing and rectifying the filtered second direct current signal and the remaining PWM signal in the at least two PWM signals.

In embodiments of the disclosure, after the processing circuit 630 rectifies the first PWM signal to obtain a second direct current signal, the second direct current signal may be mixed with some signals having other frequencies, therefore, the second direct current signal may be filtered to obtain a stable direct current signal. Further, the processing circuit 630 may superimpose and rectify the filtered second direct current signal and the remaining PWM signal in the at least two PWM signals to acquire the first direct current signal.

In embodiments of the disclosure, a structure for filtering the second DC signal may be a filter capacitor, or may be some filter circuits with a filtering function, which is not specifically limited in the present disclosure. The filter or filter circuit capable of filtering the ripple in the second direct current signal and causing a waveform of the second direct current signal to be smooth may be applied to the embodiments of the disclosure.

Since superimposing signals is superimposing the direct current signal with the PWM signal or superimposing the PWM signal with the PWM signal. For superimposing the direct current signal with the PWM signal, the superimposed PWM signal may be rectified and then superimposed with the PWM signal, or the PWM signal before being superimposed is rectified and then superimposed with the superimposed PWM signal.

In some embodiments, the processing circuit 630 is further configured to: acquire a first PWM signal by superimposing the direct current signal and one of the at least two PWM signals; acquire a third direct current signal by rectifying the remaining PWM signal in the at least two PWM signals; acquire a first direct current signal by superimposing and rectifying the third direct current signal and the first PWM signal.

In embodiments of the disclosure, the processing circuit 630 may acquire the first PWM signal by superimposing the direct current signal input by the adapter through the first interface 610 and one of the at least two PWM signals input based on the MCU through the second interface 620 and acquire the third direct current signal by rectifying the remaining PWM signal in the at least two PWM signals , and acquire the first direct current signal by superimposing and rectifying the third direct current signal and the first PWM signal. The first PWM signal in embodiments of the disclosure is acquired after the direct current signal input through the first interface 610 and one of the at least two PWM signals are superimposed, therefore, the superimposed PWM signal and the third direct current signals acquired after the remaining PWM signal in the at least two PWM signals is rectified by the processing circuit 630 may be superimposed and rectified, so as to acquire the first direct current signal.

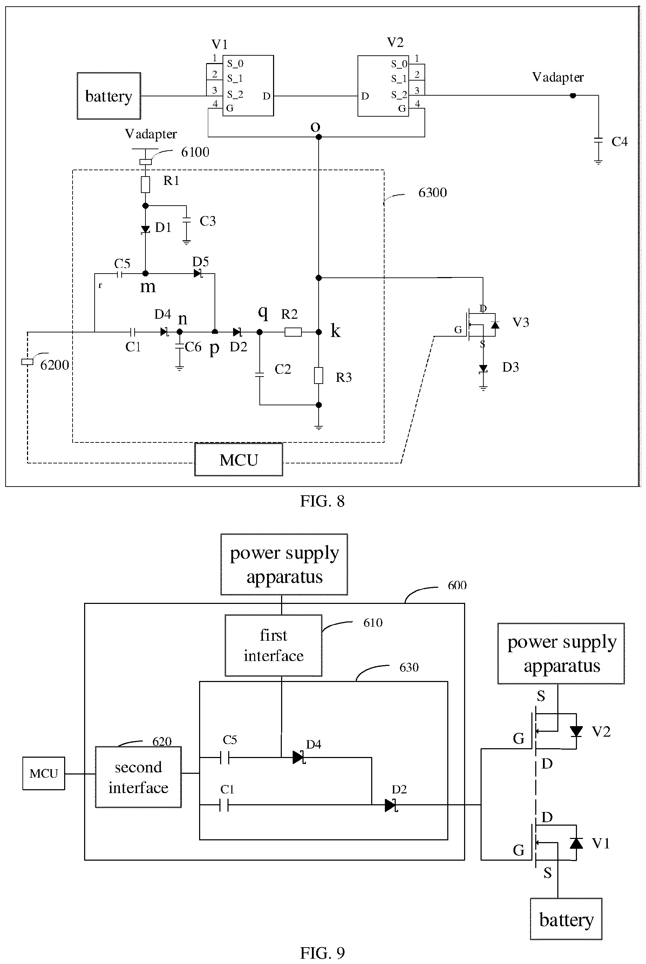

FIG. 8 is a schematic diagram illustrating a fast charge path in the embodiment of the disclosure. As can be seen from FIG. 8, the direct current signal input by the adapter and one of the at least two PWM signals input based on the MCU are superimposed at m point to acquire the first PWM signal. The first direct current signal is acquired after the remaining PWM signal in the at least two PWM signals are rectified by the diode D4, and superimposed with the first PWM signal at p point, and then rectified by D2.

Specifically, for the m point, the direct current signal input by the adapter and the PWM signal based on the MCU through the capacitor C5 are superimposed at the m point, at this time, the voltage at the m point is Vm = (Vbus-Vd) + Vclk, and after the signal at the m point is superimposed with the PWM signal rectified by the diode D4 at p point, the voltage at p point is Vp = (Vbus-3Vd) +2Vclk, and the superimposed PWM signal is rectified by the diode D2 to acquire the first direct current signal, the voltage at q point is Vq = (Vbus-4Vd) +2 Vclk.

For example, when the voltage output by the adapter is 5V, the voltage of the signal output by the MCU is 4V, and the voltage of the diode is 0.2V, the voltage of the gate of the MOS transistor is Vo= (Vbus-2Vd) +Vclk=5-0.4+4=8.6V In embodiments of the disclosure, since a voltage of one PWM signal is added, as illustrated in FIG. 8, each of the voltage of the gate of the MOS transistor V1 and the voltage of the gate of the MOS transistor V2 is VG = Vo = (Vbus-4Vd) +2Vclk=5-0.8+8=12.2V, and the voltage of the gate of the MOS transistor V1 and the voltage of the gate of the MOS transistor V2 may increase 3.6V.

In some embodiments, the processing circuit 630 is further configured to: filter the third direct current signal to acquire the filtered third direct current signal; acquire the first direct current signal by superimposing and rectifying the filtered third direct current signal and the first PWM signal.

In embodiments of the disclosure, in the third direct current signal acquired after the processing circuit 630 rectifies the remaining PWM signal in the at least two PWM signals, the third direct current signal may be mixed with some signals having other frequencies, therefore, the third direct current signal may be filtered. After the third direct current signal is filtered, the processing circuit 630 may superimpose and rectify the filtered third direct current signal and the first PWM signal to acquire the first direct current signal.

In embodiments of the disclosure, a structure for filtering the third direct current signal may be a filter capacitor, or may be some filter circuits with a filtering function, which is not specifically limited in the present disclosure. The filter or filter circuit capable of filtering the ripple in the third direct current signal causing a waveform of the third direct current signal to be smooth may be applied to the embodiments of the disclosure.

Of course, the direct current signal input by the adapter through the first interface may be filtered. In some embodiments, the processing circuit 630 is further configured to: filter the direct current signal input by the adapter through the first interface.

In embodiments of the disclosure, a structure for filtering the direct current signal input by the adapter through the first interface 610 may be a filter capacitor, or may be some filter circuits with a filtering function, which is not specifically limited in the present disclosure. The filter or filter circuit capable of filtering the ripple in the direct current signal input through the first interface and causing a waveform of the third direct current signal to be smooth may be applied to the embodiments of the disclosure.

In some embodiments, as illustrated in FIG. 9, the processing circuit 630 may include a capacitor C5, a capacitor C1, a diode D4 and a diode D2.

For the capacitor C5, one end of the capacitor C5 is connected to the second interface. For the capacitor C1, one end of the capacitor C1 is connected to the second interface. For the diode D4, an anode of the diode D4 is connected to the first interface and the other end of the capacitor C5 respectively, and a cathode of the diode D4 is connected to the other end of the capacitor C1, the diode D4 is configured to rectify the first PWM signal to acquire the second direct current signal. For the diode D2, an anode of the diode D2 is connected to a cathode of the diode D4 and the other end of the capacitor C1 respectively, and the cathode of the diode D2 is connected to a gate of a MOS transistor V1 and a gate of a MOS transistor V2, the diode D2 is configured to rectify a signal obtained after the second direct current signal and the remaining PWM signal output by the MCU are superimposed to acquire the first direct current signal. The capacitor C5 is configured to remove a direct current component from one of the at least two PWM signals before one of the at least two PWM signals is superimposed, and the capacitor C1 is configured to remove a direct current component from the remaining PWM signal in the at least two PWM signals before the remaining PWM signal in the at least two PWM signals is superimposed.

The capacitor C5, the capacitor C1, the diode D4 and the diode D2 in embodiments of the disclosure may be a capacitor C5, a capacitor C1, a diode D4 and a diode D2 in FIG. 7. For brevity, the specific process may refer to FIG. 7, which will not be described in the disclosure.

In embodiments of the disclosure, since each PWM signal input through the second interface based on the MCU may include a direct current component, each of the capacitor C5 and the capacitor C1 may be configured to remove the direct current component from the corresponding PWM signal output through the second interface.

In some embodiments, as illustrated in FIG. 10, the processing circuit 630 may further include a diode D1 and a diode D5.

For the diode D1, an anode and a cathode of the diode D1 are connected to the first interface and the other end of the capacitor C5 respectively. For the diode D5, an anode of the diode D5 is connected to a cathode of the diode D4, and a cathode of the diode D5 is connected to the other end of the capacitor C1.

The diode D1 and the diode D5 in embodiments of the disclosure may be a diode D1 and a diode D5 in FIG. 7. For brevity, the specific process may refer to FIG. 7, which will not be described in the disclosure.

In some embodiments, as illustrated in FIG. 11, the processing circuit 630 may further include a capacitor C3 and a capacitor C6.

For the capacitor C3, one end of the capacitor C3 is connected to the first interface, the other end of the capacitor C3 is grounded, and the capacitor C3 is configured to filter the direct current signal output from the first interface. For the capacitor C6, one end of the capacitor C6 is connected to a cathode of the diode D4, and the other end of the capacitor C6 is grounded, the capacitor C6 is configured to filter the second direct current signal output from the diode D4.

In embodiments of the disclosure, the direct current signal input by the adapter through the first interface may have clutters, and may therefore be filtered through the capacitor C3. Similarly, the signal acquired after the direct current signal input through the first interface and one of the PWM signals input by the MCU through the second interface are superimposed and rectified may have clutters, and may therefore be filtered through the capacitor C6.

Since superimposing the signals is superimposing the direct current signal with the PWM signal or superimposing the PWM signal with the PWM signal. For superimposing the direct current signal with the PWM signal, the superimposed PWM signal may be rectified and then superimposed with the PWM signal, or the PWM signal before being superposed is rectified and then superimposed with the superimposed PWM signal.

In some embodiments, as illustrated in FIG. 12, the processing circuit 630 may include a capacitor C5, a capacitor C1, a diode D4 and a diode D2.

For the capacitor C5, one end of the capacitor C5 is connected to the second interface. For the capacitor C1, one end of the capacitor C1 is connected to the second interface. For the diode D4, an anode of the diode D4 is connected to the other end of the capacitor C1, and a cathode of the diode D4 is connected to the first interface and the other end of the capacitor C5, the diode D4 is configured to rectify the remaining PWM signal in the at least two PWM signals to acquire the third direct current signal. For the diode D2, an anode of the diode D2 is connected to a cathode of the diode D4, the first interface and the other end of the capacitor C5, and the cathode of the diode D2 is connected to a gate of a MOS transistor V1 and a gate of a MOS transistor V2, the diode D2 is configured to rectify the signal obtained by superimposing the third direct current signal and the first PWM signal to acquire the first direct current signal. The capacitor C5 is configured to remove a direct current component from one of the at least two PWM signals before one of the at least two PWM signals is superimposed, and the capacitor C1 is configured to remove a direct current component from the remaining PWM signal in the at least two PWM signals before the remaining PWM signal in the at least two PWM signals is superimposed.

The capacitor C5, the capacitor C1, the diode D4 and the diode D2 in embodiments of the disclosure may be a capacitor C5, a capacitor C1, a diode D4 and a diode D2 in FIG. 8. For brevity, the specific process may refer to FIG. 8, which will not be described in the disclosure.

In some embodiments, as illustrated in FIG. 13, the processing circuit 630 may further include a diode D1 and a diode D5.

For the diode D1, an anode of the diode D1 is connected to the first interface 610, and a cathode of the diode D1 is connected to the other end of the capacitor C5. For the diode D5, an anode of the diode D5 is connected to the other end of the capacitor C5 and a cathode of the diode D1, and a cathode of the diode D5 is connected to a cathode of the diode D4.

The diode D1 and the diode D5 in embodiments of the disclosure may be a diode D1 and a diode D5 in FIG. 8. For brevity, the specific process may refer to FIG. 8, which will not be described in the disclosure.

In some embodiments, as illustrated in FIG. 14, the processing circuit 630 may further include a capacitor C3 and a capacitor C6.

For the capacitor C3, one end of the capacitor C3 is connected to the first interface, the other end of the capacitor C3 is grounded, and the capacitor C3 is configured to filter the direct current signal output from the first interface. For the capacitor C6, one end of the capacitor C6 is connected to the cathode of the diode D4, and the other end of the capacitor C6 is grounded, the capacitor C6 is configured to filter the third direct current signal output from the diode D4.

In embodiments of the disclosure, the direct current signal input by the adapter through the first interface may have clutters, and may therefore be filtered through the capacitor C3. Similarly, the PWM signals input by the MCU through the second interface may have clutters, and may therefore be filtered through the capacitor C6.

In some embodiments, the second interface in embodiments of the disclosure may receive a plurality of PWM signals. Taking receiving three PWM signals as an example, FIG. 15 is a schematic diagram illustrating a structure of a fast charge path in the embodiment of the disclosure. The direct current signal output by the adapter and the PWM signal through the capacitor C5 are superimposed at the m point to acquire the first PWM signal. The first PWM signal is rectified by the diode D4 to output the second direct current signal. The second direct current signal and the PWM signal through the capacitor C1 are superimposed at p point. A PWM signal at p point is superimposed with a direct current signal obtained through rectification of a diode D6 at s point and then rectified by the diode D2 to obtain the first direct current signal.

In embodiments of the disclosure, in the processing circuit 630, a plurality of PWM signals received through the second interface may be first superimposed with other direct current signals and then rectified, and also may be rectified first and then superimposed with other PWM signals, which will not be limited in the disclosure.

In embodiments of the disclosure, there may be a plurality of diodes D1 or diodes D5, in which, the diodes D1 and the diodes D5 may be the same type of diodes, and also may be different types of diodes.

Specifically, as illustrated in FIG. 15, for the p point, taking the diode D5 for an example, the diode D5 may be located at a position illustrated in FIG. 15 to avoid a reverse voltage caused due to the voltage at p point increasing. The diode D5 in embodiments of the disclosure may also be located before the diode D4 to avoid a reverse voltage caused due to the voltage at p point increasing, which may be applied to the disclosure.

In embodiments of the disclosure, there may be a plurality of diodes. As illustrated in FIG. 15, there may also be a diode D7 between p point and s point, to avoid a reverse voltage caused due to the voltage at s point increasing. It should be understood that, in embodiments of the disclosure, the MCU may output a plurality of PWM signals through the second interface, and the diode may also be located on a circuit after each PWM signal in the plurality of PWM signals is superimposed each time and before the next superimposition is performed.

In embodiments of the disclosure, the first interface 610 may be connected to the diode D1. After the direct current signal input by the adapter through the first interface and one of the at least two PWM signals input through the second interface based on the MCU are superimposed, the voltage of the superimposed signal is greater than the voltage of the direct current signal input by the adapter through the first interface, which may generate reverse voltage. Therefore, the diode D1 may avoid the reverse voltage caused due to superimposition of the direct current signal output by the adapter and the PWM signal output based on the MCU. Similarly, the diode D5 may avoid the reverse voltage caused due to the increase of the voltage at p point.

The foregoing describes that the PWM signals input based on the MCU through the second interface 620 may be at least two PWM signals. The at least two PWM signals may be the same signals. In some embodiments of the disclosure, the at least two PWM signals may also be different signals. However, it should be understood that, when the at least two PWM signals are different PWM signals, the frequencies of the PWM signals are the same, however, a length of the bandwidth of the high level of the PWM signals are different and a rising edge of the high level of the PWM signals are different.

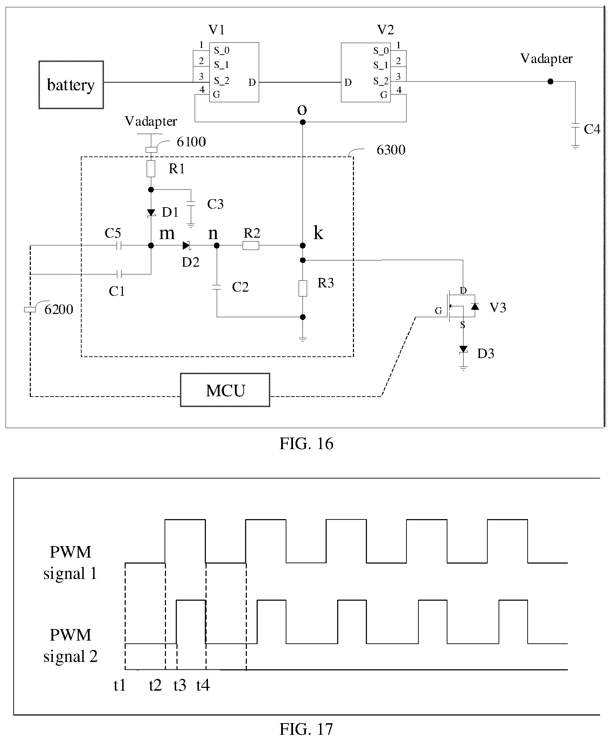

FIG. 16 is a schematic diagram illustrating a fast charge path in the embodiment of the disclosure. As can be seen from FIG. 16, the direct current signal output by the adapter and the plurality of PWM signals output based on the MCU are superimposed at the m point to acquire the first PWM signal, and the first PWM signal is rectified by the diode D2 to acquire the first direct current signal.

In this case, the voltage at the m point is Vm= (Vbus-Vd) +Vclk1+Vclk2, and reaches to n point after rectified by the diode D2, at this time, the voltage at the n point is Vn= (Vbus-2Vd) +Vclk1+Vclk2, that is, each of the voltage of the gate of the MOS transistor V1 and the voltage of the gate of the MOS transistor V2 is VG = Vo = Vn = (Vbus-2Vd) +Vclk1+Vclk2.

In general, the voltage drop across the diode is relatively small, typically 0.1 V to 0.2 V, and the voltage Vclk of the signal output by the MCU is generally about 4V. For example, in an embodiment, when the voltage output by the adapter is 5V, the voltage of the signal output by the MCU is 4V, and the voltage across the diode is 0.2V, the voltage at o point, that is, each of the voltage of the gate of the MOS transistor V1 and the voltage of the gate of the MOS transistor V2 is VG = Vo = (Vbus-2Vd) + Vclk = 5-0.4 +4 = 8.6V. In another embodiment, since one PWM signal voltage is added, the voltage of the gate of the MOS transistor is VG=Vo= (Vbus-2Vd) +Vclk1+Vclk2=5-0.4+8=12.6V

Compared with the first embodiment, each of the voltage of the gate of the MOS transistor V1 and the voltage of the gate of the MOS transistor V2 increases Vincrease = Vclk2 = 4V, therefore, in the embodiments of the present disclosure, the voltage of the gate of the MOS transistor V1 and he voltage of the gate of the MOS transistor V2 may be increased, so as to reduce the impedance between the drain and the source of each MOS transistor when the MOS transistor V1 and the MOS transistor V2 are turned on, and further avoid reducing the current or exiting the fast charging mode due to the heating of the MOS transistor V1 and the MOS transistor V2 and the overlarge impedance of the charging loop.

In embodiments of the disclosure, frequencies of the voltages Vclk1 and Vclk2 of the PWM signals output by two pins of the MCU are the same, in this case, superimposition of the voltages of the two PWM signal may increase the voltage of the gate of the MOS transistor V1 and the voltage of the gate of the MOS transistor V2.

In embodiments of the disclosure, since parallel connection of a capacitor bank may affect the voltage of the signal controlled and output by the MCU, after the voltage Vclk1 of the original signal is output for a period of time, the pin of the MCU outputs the voltage Vclk2 of the signal again, at this time, which is equivalent to adding a voltage of a signal of one branch at the m point. Therefore, the voltage Vclk1 of the original signal will not be affected.

In some embodiments, as illustrated in FIG. 17, a time of the rising edge of the newly added PWM signal 2 is greater than a time of the rising edge in the original PWM signal 1.

It may be understood that, since the time of the rising edge of the newly added PWM signal output based on the MCU is later than the time of the rising edge of the original PWM signal, and the frequencies of the two PWM signals require to be ensured the same, a width of the high level of the newly added PWM signal may be controlled less than a width of the high level of the original PWM signal.

For example, as illustrated in FIG. 17, the PWM signal 1 is an original signal in the driving circuit, and the PWM signal 2 is a newly added signal. As can be seen from the figure, frequencies of the PWM signal 1 and the PWM signal 2 are the same, that is, cycles of the two signals are the same, both from t1 to t4 in the figure. The PWM signal 1 changes to the high level from the low level at time t2, and the PWM signal 2 changes to the high level from the low level at time t3, that is, after the PWM signal 1 changes to the high level for (t3-t2) time from the low level, the PWM signal 2 changes to the high level from the low level, at this time, since the PWM signal 1 is substantially in a fully stable state, adding the PWM signal 2 does not affect the PWM signal 1.

In the driving circuit 600 provided in embodiments of the disclosure, the direct current signal input by the adapter through the first interface 610 and the at least two PWM signals input based on the MCU through the second interface are superimposed and rectified, and output to the gate of the MOS transistor in the charging path in the electronic device. The driving voltage generated by the driving circuit may be increased due to the at least two PWM signals input to the driving circuit through the second interface based on the MCU, therefore, the voltage between the gate and the source of each of the MOS transistor V1 and the MOS transistor V2 may be increased, which may avoid reducing charging efficiency caused by the voltage between the gate and the source of each of the MOS transistor V1 and the MOS transistor V2 being too low, and rapidly reducing the fast charge current or exiting the fast charge mode caused by the overlarge impedance when the MOS transistor is turned on.

FIG. 18 is a schematic diagram illustrating an electronic device 1800 in the embodiment of the disclosure. The electronic device may include a first interface 1810, a micro-controller unit (MCU) 1820, a second interface 1830, a processing circuit 1840 and a MOS transistor 1850.

The first interface 1810 connected to an external power supply apparatus is configured to receive a direct current signal input by the external power supply apparatus. The MCU 1820. The second interface 1830 connected to the MCU 1820 is configured to receive at least two pulse width modulated PWM signals input by the MCU1820. The MOS transistor 1850. The processing circuit 1840 connected to the first interface 1810 and the second interface 1830 respectively is configured to acquire a first direct current signal by superimposing and rectifying the direct current signal and the at least two PWM signals, and output the first direct current signal to a gate of the MOS transistor, to enable the voltage of the gate of the MOS transistor to be greater than a first threshold.

The processing circuit 1840 may be any one circuit in the above processing circuit 600, which will not be repeated here for brevity.

In some embodiments, the processing circuit 1840 is further configured to: acquire a first PWM signal by superimposing the direct current signal and one of the at least two PWM signals and acquire a second direct current signal by rectifying the first PWM signal; acquire the first direct current signal by superimposing and rectifying the second direct current signal and the remaining PWM signal in the at least two PWM signals.

In some embodiments, the processing circuit 1840 is further configured to: filter the second direct current signal to acquire the filtered second direct current signal; acquire the first direct current signal by superimposing and rectifying the filtered second direct current signal and the remaining PWM signal in the at least two PWM signals.

In some embodiments, the processing circuit 1840 is further configured to: acquire a first PWM signal by superimposing the direct current signal and one of the at least two PWM signals and acquire a third direct current signal by rectifying the remaining PWM signal in the at least two PWM signals; acquire the first direct current signal by superimposing and rectifying the third direct current signal and the first PWM signal.

In some embodiments, the processing circuit 1840 is further configured to: filter the third direct current signal to acquire the filtered third direct current signal; acquire the first direct current signal by superimposing and rectifying the filtered third direct current signal and the first PWM signal.

In some embodiments, the processing circuit 1840 is further configured to: filter the direct current signal input by the external power supply apparatus through the first interface.

In some embodiments, the processing circuit 1840 includes: a capacitor C5, one end of the capacitor C5 being connected to the second interface; a capacitor C1, one end of the capacitor C1 being connected to the second interface; a diode D4, an anode of the diode D4 being connected to the first interface and the other end of the capacitor C5, a cathode of the diode D4 being connected to the other end of the capacitor C1, configured to rectify the first PWM signal to acquire the second direct current signal; a diode D2, an anode of the diode D2 being connected to a cathode of the diode D4 and the other end of the capacitor C1, the cathode of the diode D2 being connected to a gate of a MOS transistor V1 and a gate of a MOS transistor V2, configured to rectify the signal obtained by superimposing the second direct current signal and the remaining PWM signal output by the MCU to acquire the first direct current signal. The capacitor C5 is configured to remove a direct current component from one of the at least two PWM signals before one of the at least two PWM signals is superimposed, and the capacitor C1 is configured to remove a direct current component from the remaining PWM signal in the at least two PWM signals before the remaining PWM signal in the at least two PWM signals is superimposed.

In some embodiments, the processing circuit 1840 further includes: a diode D1, an anode of the diode D1 being connected to the first interface 610 and a cathode of the diode D1 being connected to the other end of the capacitor C5; a diode D5, an anode of the diode D5 being connected to a cathode of the diode D4, and a cathode of the diode D5 being connected to the other end of the capacitor C1.

In some embodiments, the processing circuit 1840 further includes: a capacitor C3, one end of the capacitor C3 being connected to the first interface, and the other end of the capacitor C3 being grounded, configured to filter the direct current signal output from the first interface; a capacitor C6, one end of the capacitor C6 being connected to the cathode of the diode D4, and the other end of the capacitor C6 being grounded, configured to filter the third direct current signal output from the diode D4.

In some embodiments, the processing circuit 1840 further includes: a capacitor C5, one end of the capacitor C5 being connected to the second interface; a capacitor C1, one end of the capacitor C1 being connected to the second interface; a diode D4, an anode of the diode D4 being connected to the other end of the capacitor C1, a cathode of the diode D4 being connected to the first interface and the other end of the capacitor C5, configured to rectify the remaining PWM signal in the at least two PWM signals to acquire the third direct current signal; a diode D2, an anode of the diode D2 being connected to a cathode of the diode D4, the first interface and the other end of the capacitor C5, the cathode of the diode D2 being connected to a gate of a MOS transistor V1 and a gate of a MOS transistor V2, configured to rectify the signal obtained by superimposing the third direct current signal and the first PWM signal to acquire the first direct current signal. The capacitor C5 is configured to remove a direct current component from one of the at least two PWM signals before one of the at least two PWM signals is superimposed, and the capacitor C1 is configured to remove a direct current component from the remaining PWM signal in the at least two PWM signals before the remaining PWM signal in the at least two PWM signals is superimposed

In some embodiments, the processing circuit 1840 further includes: a diode D1, an anode of the diode D1 being connected to the first interface 610 and a cathode of the diode D1 being connected to the other end of the capacitor C5; a diode D5, an anode of the diode D5 being connected to the other end of the capacitor C5 and the cathode of the diode D1, and a cathode of the diode D5 being connected to the cathode of the diode D4.

In some embodiments, the processing circuit 1840 further includes: a capacitor C3, one end of the capacitor C3 being connected to the first interface, and the other end of the capacitor C3 being grounded, configured to filter the direct current signal output from the first interface; a capacitor C6, one end of the capacitor C6 being connected to the cathode of the diode D4, and the other end of the capacitor C6 being grounded, configured to filter the third direct current signal output from the diode D4.

In combination with FIGS. 1-18, apparatus embodiments in the disclosure are described, and in combination with FIGS. 19-23, method embodiments in the disclosure are described. The apparatus embodiments correspond to the method embodiments, therefore, for the parts not described, please refer to apparatus embodiments.

FIG. 19 illustrates a method 1900 for controlling charging in the embodiment of the disclosure. The method 1900 may include blocks 1910-1920.

At block 1910, a first direct current signal is acquired by superimposing and rectifying the direct current signal input by the external power supply apparatus through the first interface and the at least two PWM signals input by the MCU through the second interface.

At block 1920, the first direct current signal is output to a gate of the MOS transistor, to enable a voltage of the gate of the MOS transistor to be greater than a first threshold.

In some embodiments, acquiring a first direct current signal by superimposing and rectifying the direct current signal output by the external power supply apparatus through the first interface and the at least two PWM signals output by the MCU through the second interface, includes: acquiring a first PWM signal by superimposing the direct current signal input by the external power supply apparatus through the first interface and one of the at least two PWM signals and acquiring a second direct current signal by rectifying the first PWM signal; acquiring the first direct current signal by superimposing and rectifying the second direct current signal and the remaining PWM signal in the at least two PWM signals.

In some embodiments, the method 1900 further includes: filtering the second direct current signal to acquire the filtered second direct current signal. Acquiring the first direct current signal by superimposing and rectifying the second direct current signal and the remaining PWM signal in the at least two PWM signals includes: acquiring the first direct current signal by superimposing and rectifying the filtered second direct current signal and the remaining PWM signal in the at least two PWM signals.

In some embodiments, acquiring the first direct current signal by superimposing and rectifying the direct current signal output by the external power supply apparatus through the first interface and the at least two PWM signals output by the MCU through the second interface , includes: acquiring a first PWM signal by superimposing the direct current signal input by the external power supply apparatus through the first interface and one of the at least two PWM signals; and acquiring a third direct current signal by rectifying the remaining PWM signal in the at least two PWM signals; and acquiring the first direct current signal by superimposing and rectifying the third direct current signal and the first PWM signal.

In some embodiments, the method 1900 further includes: filtering the third direct current signal to acquire the filtered third direct current signal; acquiring the first direct current signal by superimposing and rectifying the third direct current signal and the first PWM signal includes: acquiring the first direct current signal by superimposing and rectifying the filtered third direct current signal and the first PWM signal.

In some embodiments, as illustrated in FIG. 20, the method 1900 may further include block 1930.

At block 1930, the direct current signal input by the external power supply apparatus through the first interface is filtered.

In some embodiments, as illustrated in FIG. 21, the method 1900 may further include block 1940.

At block 1940, direct current components are removed from the at least two PWM signals before the at least two PWM signals are superimposed.

The embodiments of the disclosure further provide a computer readable storage medium stored with executable computer instructions thereon, the executable computer instructions are configured to execute any of the above methods 1900.

The embodiments of the disclosure further provide a computer program product including computer instructions stored on the computer readable storage medium, the computer program including program instructions. When the program instructions are executed by a computer, the computer is caused to execute any of the above methods 1900.

The solution of embodiments of the disclosure may be applied to a wired charging process.

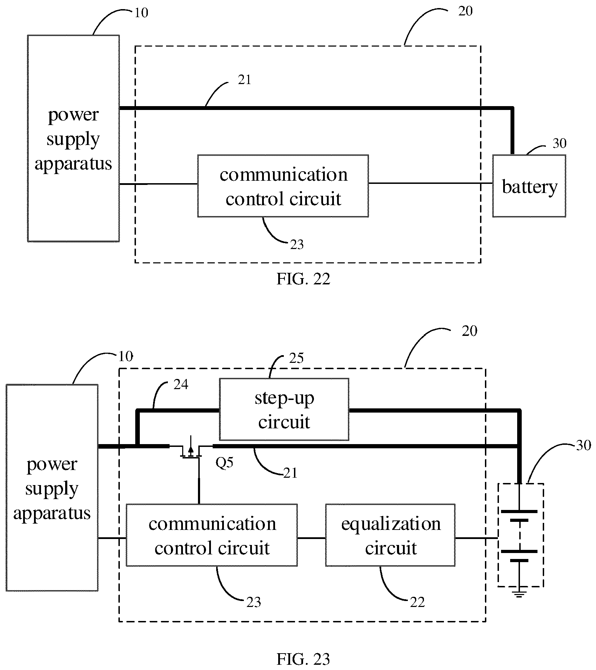

In combination with FIGS. 22-23, a wired charging process applied in embodiments of the disclosure is described.

FIG. 22 is a schematic diagram illustrating a structure of a charging system in the embodiment of the disclosure. The charging system includes a power supply apparatus 10, a battery management circuit 20, and a battery 30. The battery management circuit 20 may be configured to manage the battery 30.

As an example, the battery management circuit 20 may manage a charging process of the battery 30, such as selecting a charging channel, controlling a charging voltage and/or a charging current, etc.; as another example, the battery management circuit 20 may manage cells of the battery 30, for example, equalizing voltages of the cells in the battery 30, etc.

The battery management circuit 20 may include a first charging channel 21 and a communication control circuit 23.

The first charging channel 21 may be configured to receive a charging voltage and/or a charging current provided by the power supply apparatus 10, and load the charging voltage and/or the charging current on both ends of the battery 30 to charge the battery 30.

The first charging channel 21 may be, for example, a wire, or may be provided with some other circuit components unrelated with transformation of the charging voltage and/or the charging current on the first charging channel 21. For example, the power management circuit 20 includes a first charging channel 21 and a second charging channel, and the first charging channel 21 may be provided with a switching device for switching between charging channels (see description of FIG. 23).

Types of the power supply apparatus 10 in the embodiment of the disclosure may be not specifically limited. For example, the power supply apparatus 10 may be a device specifically for charging, such as an adapter and a power bank, or may be a computer or other devices capable of providing power and data services.

The first charging channel 21 may be a direct charging channel, and the charging voltage and/or charging current provided by the power supply apparatus 10 may be directly loaded on both ends of the battery 30. In order to achieve a direct charging mode, the embodiment of the disclosure introduces a control circuit having a communication function, that is, a communication control circuit 23, in the battery management circuit 20. The communication control circuit 23 may maintain communication with the power supply apparatus 10 during the direct charging process to form a closed-loop feedback mechanism, so that the power supply apparatus 10 may obtain a state of the battery in real time, so as to continuously adjust the charging voltage and/or the charging current injected to the first charging channel, which may ensure that the charging voltage and/or the charging current provided by the power supply apparatus 10 matches a charging stage where the battery 30 presently is.

For example, the communication control circuit 23 may communicate with the power supply apparatus 10 when a voltage of the battery 30 reaches a charging cut-off voltage corresponding to a constant current stage, such that the power supply apparatus 10 converts the charging process of the battery 30 to constant-voltage charging from constant-current charging. For another example, the communication control circuit 23 may communicate with the power supply apparatus 10 when a charging current of the battery 30 reaches a charging cut-off current corresponding to a constant current stage, the communication control circuit 23 communicates with the power supply apparatus 10, such that the power supply apparatus 10 converts the charging process of the battery 30 to constant-current charging from constant-voltage charging. The communication control circuit 23 in embodiments of the disclosure may be the above driving circuit.

The battery management circuit provided in embodiments of the disclosure may directly charge the battery, in other words, the battery management circuit provided in embodiments of the disclosure is a battery management circuit supporting a direct charging architecture, and in the direct charging architecture, a conversion circuit does not require to be arranged on the direct charging channel, thereby reducing a calorific value of a device to be charged during the charging process. In some embodiments, as illustrated in FIG. 23, the battery management circuit 20 may further include a second charging channel 24. The second charging channel 24 is provided with a step-up circuit 25. In the process of the power supply apparatus 10 charging the battery 30 through the second charging channel 24, the step-up circuit 25 may be configured to receive an initial voltage provided by the power supply apparatus 10, boost the initial voltage to a target voltage, and charge the battery 30 based on the target voltage. The initial voltage is less than a total voltage of the battery 30, and the target voltage is greater than the total voltage of the battery 30. The communication control circuit 23 may be further configured to control switching between the first charging channel 21 and the second charging channel 24.

Assuming that the battery 30 includes a plurality of cells, the second charging channel 24 may be compatible with a common power supply apparatus for charging the battery 30, thereby solving a problem that the common power supply apparatus may not charge the plurality of cells.

For the battery 30 including the plurality of cells, the battery management circuit 20 may further include an equalization circuit 22. Referring to the above description, the equalization circuit 22 may be configured to equalize voltages of the plurality of cells during a charging process and/or a discharging process of the battery.

The specific form of the step-up circuit 25 is not limited in the embodiments of the disclosure. For example, the step-up circuit 25 may be a boost circuit, and may be configured for boosting via a charge pump. In some embodiments, the second charging channel 24 may adopt a conventional charging channel design mode, that is, a conversion circuit (such as a charging IC) is provided on the second charging channel 24. The conversion circuit may perform constant voltage and constant current control on the charging process of the battery 30, and adjust the initial voltage provided by the power supply apparatus 10 according to actual requirements, such as stepping up or stepping down voltage. In embodiments of the disclosure, a step-up function of the conversion circuit may be utilized to step up the initial voltage provided by the power supply apparatus 10 to the target voltage.

The communication control circuit 23 may implement the switching between the first charging channel 21 and the second charging channel 24 through the switching element. Specifically, as illustrated in FIG. 23, the first charging channel 21 may be provided with a switch tube Q5, and when the communication control circuit 23 controls the switch tube Q5 to be turned on, the first charging channel 21 operates to directly charge the battery 30; and when the communication control circuit 23 controls the switch tube Q5 to be turned off, the second charging channel 24 operates to charge the battery 30 via the second charging channel 24. The switch tube Q5 in the embodiments of the disclosure may be a MOS transistor, or may be a switch.

In some other embodiments, a step-down circuit or a step-down device may be further provided on the second charging channel 24, and when the voltage provided by the power supply apparatus is higher than a voltage required by the battery 30, step-down processing may be performed. In embodiments of the disclosure, the circuit or module in the second charging channel 24 is not limited.

In the above embodiments, it may be implemented in whole or in part with hardware, software, a firmware and their combination. When implemented by the software, all or some may be implemented in the form of a computer program product. The computer program product includes one or more computer instructions. When the computer program instructions are loaded and executed on a computer, the processes or functions according to the embodiments of the disclosure are completely or partially generated. The computer may be a general-purpose computer, a special-purpose computer, a computer network, or other programmable apparatus. The computer instructions may be stored in a computer-readable storage medium or transmitted from one computer-readable storage medium to another, for example, the computer instructions may be transmitted from one website site, a computer, a server or a data center to another website site, computer, server, or data center in a wired (for example, a coaxial cable, an optical fiber, a digital subscriber line (DSL)) or wireless (for example, infrared, wireless, microwave, etc.) way. The computer readable storage medium may be any available medium accessible by a computer or a data storage device such as a server or a data center integrated with one or more available media. The available medium may be a magnetic medium (for example, a floppy disk, a hard disk, a magnetic tape), an optical medium (for example, a digital video disc (DVD)), or a semiconductor medium (such as a solid state disk (SSD)).

Those skilled in the art may realize that the units and algorithm steps of the examples described in connection with the embodiments disclosed herein may be implemented by an electronic hardware, or a combination of computer software and an electronic hardware. Whether the functions are performed by hardware or software depends on particular applications and design constraints of the technical solutions. The technical professionals may implement the described functions for each particular application with different methods, however, the implementation should not be considered beyond the application scope.

In several embodiments of the disclosure, it should be understood that the system, apparatus and method disclosed may be implemented in other manners. For example, the apparatus embodiments described above are merely schematic, for example, the division of the units is merely a logical function division, and there may be another division method in actual implementation, for example, a plurality of units or components may be combined or integrated into another system, or some features may be ignored or not performed. In addition, the mutual coupling or direct coupling or communication connection displayed or discussed may be an indirect coupling or communication connection of apparatuses and units through some interfaces, and may be in electrical, mechanical or other forms.

Even though the terms "first", "second", etc. may be configured to describe various devices, the devices should not be limited by these terms. These terms are only configured to distinguish one device from another. For example, when the meaning of the description is not changed, a first device may be referred to as a second device, and similarly, a second device may be referred to as a first device, as long as each "first device" occurred is renamed and each "second device" occurred is renamed. The first device and the second device are both devices, but may not be the same device.

The units described as separate parts may or may not be physically separated, and parts displayed as units may or may not be physical units, that is, may be located in one place, or may be distributed on a plurality of network units. Some or all of the units may be selected according to actual requirements to achieve the solutions in the embodiments.

In addition, functional units in the embodiments of the disclosure may be integrated in one processing unit, or each of the units may be physically existed alone, or two or more units may be integrated in one unit.

The above are only specific implementations of the disclosure, however, the protection scope of the present disclosure is not limited here, and those skilled in the art may easily think of any changes or substitutions within the technical scope of the present disclosure, which shall be within the protection scope of the disclosure. Therefore, the protection scope of the disclosure shall be subject to the protection scope of the claims.

## Claims

1. A driving circuit, applicable for an electronic device, wherein the electronic device further comprises a MOS field effect transistor and a micro-controller unit (MCU),
wherein the driving circuit comprises:
a first interface connected to an external power supply apparatus, configured to receive a direct current signal input by the external power supply apparatus;
a second interface connected to the MCU, configured to receive at least two pulse width modulated PWM signals input by the MCU;
a processing circuit connected to the first interface and the second interface respectively, configured to acquire a first direct current signal by superimposing and rectifying the direct current signal and the at least two PWM signals, and output the first direct current signal to a gate of the MOS transistor, to enable a voltage of the gate of the MOS transistor to be greater than a first threshold.

2. The driving circuit of claim 1, wherein, the processing circuit is further configured to:
acquire a first PWM signal by superimposing the direct current signal and one of the at least two PWM signals and acquire a second direct current signal by rectifying the first PWM signal;
acquire the first direct current signal by superimposing and rectifying the second direct current signal and a remaining PWM signal in the at least two PWM signals.

3. The driving circuit of claim 2, wherein, the processing circuit is further configured to:
filter the second direct current signal to acquire the filtered second direct current signal;
acquire the first direct current signal by superimposing and rectifying the filtered second direct current signal and the remaining PWM signal in the at least two PWM signals.

4. The driving circuit of claim 1, wherein, the processing circuit is further configured to:
acquire a first PWM signal by superimposing the direct current signal and one of the at least two PWM signals;
acquire a third direct current signal by rectifying a remaining PWM signal in the at least two PWM signals, and acquire the first direct current signal by superimposing and rectifying the third direct current signal and the first PWM signal.

5. The driving circuit of claim 4, wherein, the processing circuit is further configured to:
filter the third direct current to acquire the filtered third direct current signal;
acquire the first direct current signal by superimposing and rectifying the filtered third direct current signal and the first PWM signal.

6. The driving circuit of any of claims 1 to 5, wherein, the processing circuit is further configured to:
filter the direct current signal input by the external power supply apparatus through the first interface.

7. The driving circuit of claim 2 or 3, wherein, the processing circuit comprises:
a capacitor C5, one end of the capacitor C5 being connected to the second interface;
a capacitor C1, one end of the capacitor C1 being connected to the second interface;
a diode D4, an anode of the diode D4 being connected to the first interface and the other end of the capacitor C5 respectively, a cathode of the diode D4 being connected to the other end of the capacitor C1, configured to rectify the first PWM signal to acquire the second direct current signal;
a diode D2, an anode of the diode D2 being connected to a cathode of the diode D4 and the other end of the capacitor C1 respectively, the cathode of the diode D2 being connected to a gate of a MOS transistor V1 and a gate of a MOS transistor V2, configured to rectify a signal obtained by superimposing the second direct current signal and the remaining PWM signal output by the MCU to acquire the first direct current signal;
wherein, the capacitor C5 is configured to remove a direct current component from one of the at least two PWM signals before one of the at least two PWM signals is superimposed, and the capacitor C1 is configured to remove a direct current component from the remaining PWM signal in the at least two PWM signals before the remaining PWM signal in the at least two PWM signals is superimposed.

8. The driving circuit of claim7, wherein, the processing circuit further comprises:
a diode D1, an anode of the diode D1 being connected to the first interface and a cathode of the diode D1 being connected to the other end of the capacitor C5;
a diode D5, an anode of the diode D5 being connected to a cathode of the diode D4, and a cathode of the diode D5 being connected to the other end of the capacitor C1.

9. The driving circuit of claim 7 or 8, wherein, the processing circuit further comprises:
a capacitor C3, one end of the capacitor C3 being connected to the first interface, and the other end of the capacitor C3 being grounded, configured to filter the direct current signal output from the first interface;
a capacitor C6, one end of the capacitor C6 being connected to the cathode of the diode D4, and the other end of the capacitor C6 being grounded, configured to filter the second direct current signal output from the diode D4.

10. The driving circuit of claim 4 or 5, wherein, the processing circuit comprises:
a capacitor C5, one end of the capacitor C5 being connected to the second interface;
a capacitor C1, one end of the capacitor C1 being connected to the second interface;
a diode D4, an anode of the diode D4 being connected to the other end of the capacitor C1, a cathode of the diode D4 being connected to the first interface and the other end of the capacitor C5, configured to rectify the remaining PWM signal in the at least two PWM signals to acquire the third direct current signal;
a diode D2, an anode of the diode D2 being connected to a cathode of the diode D4, the first interface and the other end of the capacitor C5, a cathode of the diode D2 being connected to a gate of a MOS transistor V1 and a gate of a MOS transistor V2, configured to rectify a signal obtained by superimposing the third direct current signal and the first PWM signal to acquire the first direct current signal;
wherein, the capacitor C5 is configured to remove a direct current component from one of the at least two PWM signals before one of the at least two PWM signals is superimposed, and the capacitor C1 is configured to remove a direct current component from the remaining PWM signal in the at least two PWM signals before the remaining PWM signal in the at least two PWM signals is superimposed.

11. The driving circuit of claim 10, wherein, the processing circuit further comprises:
a diode D1, an anode of the diode D1 being connected to the first interface and a cathode of the diode D1 is connected to the other end of the capacitor C5;
a diode D5, an anode of the diode D5 being connected to the other end of the capacitor C5 and the cathode of the diode D1, and a cathode of the diode D5 being connected to the cathode of the diode D4.

12. The driving circuit of claim 10 or 11, wherein, the processing circuit further comprises:
a capacitor C3, one end of the capacitor C3 being connected to the first interface, and the other end of the capacitor C3 being grounded, configured to filter the direct current signal output from the first interface;
a capacitor C6, one end of the capacitor C6 being connected to the cathode of the diode D4, and the other end of the capacitor C6 being grounded, configured to filter the third direct current signal output from the diode D4.

13. An electronic device, comprising:
a first interface connected to an external power supply apparatus, configured to receive a direct current signal input by the external power supply apparatus;
a micro-controller unit (MCU);
a second interface connected to the MCU, configured to receive at least two pulse width modulated PWM signals input by the MCU;
a MOS transistor;
a processing circuit connected to the first interface and the second interface respectively, configured to acquire a first direct current signal by superimposing and rectifying the direct current signal and the at least two PWM signals, and output the first direct current signal to a gate of the MOS transistor, to enable a voltage of the gate of the MOS transistor to be greater than a first threshold.

14. The electronic device of claim 13, wherein, the processing circuit is further configured to:
acquire a first PWM signal by superimposing the direct current signal and one of the at least two PWM signals and acquire a second direct current signal by rectifying the first PWM signal;
acquire the first direct current signal by superimposing and rectifying the second direct current signal and a remaining PWM signal in the at least two PWM signals.

15. The electronic device of claim 14, wherein, the processing circuit is further configured to:
filter the second direct current to acquire the filtered second direct current signal;
acquire the first direct current signal by superimposing and rectifying the filtered second direct current signal and the remaining PWM signal in the at least two PWM signals.

16. The electronic device of claim 13, wherein, the processing circuit is further configured to:
acquire a first PWM signal by superimposing the direct current signal and one of the at least two PWM signals;
acquire a third direct current signal by rectifying a remaining PWM signal in the at least two PWM signals, and acquire the first direct current signal by superimposing and rectifying the third direct current signal and the first PWM signal.

17. The electronic device of claim 16, wherein, the processing circuit is further configured to:
filter the third direct current to acquire the filtered third direct current signal;
acquire the first direct current signal by superimposing and rectifying the filtered third direct current signal and the first PWM signal.

18. The electronic device of any of claims 13 to 17, wherein, the processing circuit is further configured to:
filter the direct current signal input by the external power supply apparatus through the first interface.

19. The electronic device of claim 14 or 15, wherein, the processing circuit comprises:
a capacitor C5, one end of the capacitor C5 being connected to the second interface;
a capacitor C1, one end of the capacitor C1 being connected to the second interface;
a diode D4, an anode of the diode D4 being connected to the first interface and the other end of the capacitor C5, a cathode of the diode D4 being connected to the other end of the capacitor C1, configured to rectify the first PWM signal to acquire the second direct current signal;
a diode D2, an anode of the diode D2 being connected to a cathode of the diode D4 and the other end of the capacitor C1, the cathode of the diode D2 being connected to the gate of a MOS transistor V1 and a gate of a MOS transistor V2, configured to rectify a signal obtained by superimposing the second direct current signal and the remaining PWM signal output by the MCU to acquire the first direct current signal;
wherein, the capacitor C5 is configured to remove a direct current component from one of the at least two PWM signals before one of the at least two PWM signals is superimposed, and the capacitor C1 is configured to remove a direct current component from the remaining PWM signal in the at least two PWM signals before the remaining PWM signal in the at least two PWM signals is superimposed.

20. The electronic device of claim 19, wherein, the processing circuit further comprises:
a diode D1, an anode of the diode D1 being connected to the first interface and a cathode of the diode D1 being connected to the other end of the capacitor C5;
a diode D5, an anode of the diode D5 being connected to a cathode of the diode D4, and a cathode of the diode D5 being connected to the other end of the capacitor C1.

21. The electronic device of claim 19 or 20, wherein, the processing circuit further comprises:
a capacitor C3, one end of the capacitor C3 being connected to the first interface, and the other end of the capacitor C3 being grounded, configured to filter the direct current signal output from the first interface;
a capacitor C6, one end of the capacitor C6 being connected to the cathode of the diode D4, and the other end of the capacitor C6 being grounded, configured to filter the second direct current signal output from the diode D4.

22. The electronic device of claim 16 or 17, wherein, the processing circuit comprises:
a capacitor C5, one end of the capacitor C5 being connected to the second interface;
a capacitor C1, one end of the capacitor C1 being connected to the second interface;
a diode D4, an anode of the diode D4 being connected to the other end of the capacitor C1, a cathode of the diode D4 being connected to the first interface and the other end of the capacitor C5, configured to rectify the remaining PWM signal in the at least two PWM signals to acquire the third direct current signal;
a diode D2, an anode of the diode D2 being connected to a cathode of the diode D4, the first interface and the other end of the capacitor C5, a cathode of the diode D2 being connected to a gate of a MOS transistor V1 and a gate of a MOS transistor V2, configured to rectify a signal obtained by superimposing the third direct current signal and the first PWM signal to acquire the first direct current signal;
wherein, the capacitor C5 is configured to remove a direct current component from one of the at least two PWM signals before one of the at least two PWM signals is superimposed, and the capacitor C1 is configured to remove a direct current component from the remaining PWM signal in the at least two PWM signals before the remaining PWM signal in the at least two PWM signals is superimposed.

23. The electronic device of claim 22, wherein, the processing circuit further comprises:
a diode D1, an anode of the diode D1 being connected to the first interface and a cathode of the diode D1 is connected to the other end of the capacitor C5;
a diode D5, an anode of the diode D5 being connected to the other end of the capacitor C5 and the cathode of the diode D1, and a cathode of the diode D5 being connected to the cathode of the diode D4.

24. The electronic device of claim 22 or 23, wherein, the processing circuit further comprises:
a capacitor C3, one end of the capacitor C3 being connected to the first interface, and the other end of the capacitor C3 being grounded, configured to filter a direct current signal output from the first interface;
a capacitor C6, one end of the capacitor C6 being connected to the cathode of the diode D4, and the other end of the capacitor C6 being grounded, configured to filter the third direct current signal output from the diode D4.

25. A method for controlling charging, comprising:
acquiring a first direct current signal by superimposing and rectifying a direct current signal input by an external power supply apparatus through a first interface and at least two PWM signals input by a MCU through a second interface;
outputting the first direct current signal to a gate of a MOS transistor, to enable a voltage of the gate of the MOS transistor to be greater than a first threshold.

26. The method of claim 25, wherein, acquiring the first direct current signal by superimposing and rectifying the direct current signal output by the external power supply apparatus through the first interface and the at least two PWM signals output by the MCU through the second interface comprising:
acquiring a first PWM signal by superimposing the direct current signal input by the external power supply apparatus through the first interface and one of the at least two PWM signals and acquiring a second direct current signal by rectifying the first PWM signal;
acquiring the first direct current signal by superimposing and rectifying the second direct current signal and a remaining PWM signal in the at least two PWM signals.

27. The method of claim 26, further comprising:
filtering the second direct current to acquire the filtered second direct current signal;
wherein acquiring the first direct current signal by superimposing and rectifying the second direct current signal and the remaining PWM signal in the at least two PWM signals comprises:
acquiring the first direct current signal by superimposing and rectifying the filtered second direct current signal and the remaining PWM signal in the at least two PWM signals.

28. The method of claim 25, wherein, acquiring the first direct current signal by superimposing and rectifying the direct current signal output by the external power supply apparatus through the first interface and the at least two PWM signals input by the MCU through the second interface, comprises:
acquiring a first PWM signal by superimposing the direct current signal input by the external power supply apparatus through the first interface and one of the at least two PWM signals;
acquiring a third direct current signal by rectifying a remaining PWM signal in the at least two PWM signals, and acquiring the first direct current signal by superimposing and rectifying the third direct current signal and the first PWM signal.

29. The method of claim 28, further comprising:
filtering the third direct current signal to acquire the filtered third direct current signal;
wherein acquiring the first direct current signal by superimposing and rectifying the third direct current signal and the first PWM signal, comprises:
acquiring the first direct current signal by superimposing and rectifying the filtered third direct current signal and the first PWM signal.

30. The method of any of claims 25 to 29, further comprising:
filtering the direct current signal input by the external power supply apparatus through the first interface.

31. The method of any of claims 25 to 30, further comprising:
removing direct current components respectively from the at least two PWM signals before the at least two PWM signals are superimposed.

32. A computer readable storage medium having computer programs stored thereon, wherein the computer programs are configured for causing a computer to execute the method of any of claims 25 to 31.
